(19) **Europäisches Patentamt**
**European Patent Office**
**Office européen des brevets**

(11) **EP 4 526 692 B1**

(12) **EUROPÄISCHE PATENTSCHRIFT**

(45) Veröffentlichungstag und Bekanntmachung des Hinweises auf die Patenterteilung:
**11.03.2026 Patentblatt 2026/11**

(21) Anmeldenummer: **23726126.8**

(22) Anmeldetag: **15.05.2023**

(51) Internationale Patentklassifikation (IPC):
**G01R 31/55** (2020.01) **G01R 31/67** (2020.01)
**G01R 31/50** (2020.01) **G01R 31/58** (2020.01)

(52) Gemeinsame Patentklassifikation (CPC):
**G01R 31/55; G01R 31/67;** G01R 31/50;
G01R 31/58

(86) Internationale Anmeldenummer:
**PCT/EP2023/062961**

(87) Internationale Veröffentlichungsnummer:
**WO 2023/222596 (23.11.2023 Gazette 2023/47)**

(54) **VERFAHREN ZUM PRÜFEN EINER VERDRAHTUNG EINER ELEKTRISCHEN ANLAGE**

METHOD FOR TESTING A WIRING OF AN ELECTRICAL INSTALLATION

PROCÉDÉ DE TEST D'UN CÂBLAGE D'UNE INSTALLATION ÉLECTRIQUE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **17.05.2022 AT 503482022**

(43) Veröffentlichungstag der Anmeldung:
**26.03.2025 Patentblatt 2025/13**

(73) Patentinhaber: **Omicron electronics GmbH**
**6833 Klaus (AT)**

(72) Erfinder: **SCHMIDBAUER, Josef**
**5020 Salzburg (AT)**

(74) Vertreter: **Kraus & Lederer PartGmbB**
**Thomas-Wimmer-Ring 15**
**80539 München (DE)**

(56) Entgegenhaltungen:
**DE-A1- 102014 008 750 US-A- 3 441 842**
**US-A1- 2004 008 018**

EP 4 526 692 B1

**Beschreibung**

GEBIET DER ERFINDUNG

Die vorliegende Erfindung betrifft Verfahren zum Prüfen einer Verdrahtung einer elektrischen Anlage, insbesondere zum Prüfen einer Verdrahtung einer elektrischen Anlage mit mehreren Stromkreisen, beispielsweise eine energietechnische elektrische Anlage in beispielsweise einem Umspannwerk oder einem Kraftwerk.

HINTERGRUND

Bei einer Installation, Reparatur oder Erweiterung einer elektrischen Anlage, beispielsweise in einem Umspannwerk oder einem Kraftwerk, können Verdrahtungsfehler auftreten. Insbesondere bei Anlagen mit mehreren Stromkreisen und/oder mehreren Phasen, beispielsweise Anlagen für dreiphasigen Wechselstrom, können Leiter vertauscht werden, beispielsweise können zwei Außenleiter vertauscht werden oder ein Außenleiter mit dem Neutralleiter. Weiterhin kann beispielsweise beim Anschluss eines Transformators eine Polarität vertauscht werden. Vor einer Inbetriebnahme oder einer Wiederinbetriebnahme einer elektrischen Anlage wird daher üblicherweise eine Prüfung der Verdrahtung durchgeführt, um falsch angeschlossene Leiter und vertauschte Polaritäten festzustellen.

Beispielsweise können Prüfsignale nacheinander in die einzelnen Phasen an einer Einspeisestelle eingespeist werden und an einer davon entfernten Messstelle, an welcher gemäß Soll-Verdrahtung eine Wirkung des Prüfsignals auftreten sollte, ein Messsignal erfasst werden. Wird an der Messstelle nicht die erwartete Wirkung des Prüfsignals erfasst, könnte ein Verdrahtungsfehler vorliegen. Diese Vorgehensweise ist verhältnismäßig aufwändig, da zum Überprüfen mehrerer Stromkreise und Phasen etliche Messungen durchzuführen sind und das Messgerät für jede Messung entsprechend an der Einspeisestelle und der Messstelle anzuschließen ist. Ferner kann mit einer derartigen Messung zwar festgestellt werden, dass ein Verdrahtungsfehler vorliegt, es ist jedoch nicht unmittelbar möglich, festzustellen, welcher Art der Verdrahtungsfehler ist, ob beispielsweise Leiter vertauscht oder nicht angeschlossen sind.

Viele energietechnische Systeme verwenden ein drei Phasen Drehstromsystem. Ebenso besitzen viele Prüfgeräte mindestens drei Strom- oder Spannungsausgänge. Mithilfe dieser Prüfgeräte können daher Prüfsignale parallel eingespeist werden und die Verdrahtung aller Phasen in einem Arbeitsgang geprüft werden. Dazu kann beispielsweise ein Prüfsignal mit unterschiedlichen Amplituden für die verschiedenen Phasen verwendet werden. Insbesondere können dabei Amplituden für Ströme und Spannungen verwendet werden, deren Kombination und/oder Subtraktion neue Amplituden ergeben, die sonst nicht vorkommen.

Beispiel:

| | | | |
|---|---|---|---|
| L1 = 3 | L1 + L2 = 8 | L1 - L2 = - 2 | L1+L2+L3 = 17 |
| L2 = 5 | L1 + L3 = 12 | L1 - L3 = - 6 | L1+L2-L3 = -1 |
| L3 = 9 | L2 + L3 = 14 | L2 - L3 = - 4 | L1-L2+L3 = 7 |
| | | | -L1+L2+L3 = 11 |

Damit lassen sich Verdrahtungsfehler aufgrund der gemessenen Amplitude erkennen, z.B. wenn der Rückleiter einer Phase falsch angeschlossen ist.

Die Strom- oder Spannungsamplituden müssen sich jedoch relativ stark unterscheiden, um eine eindeutige Zuordnung durchführen zu können. Daher kann nicht immer mit Amplituden in der Nähe des Nominalbereichs der Betriebsmittel (z.B. 1A, 5A oder 100V) gearbeitet werden. Weiterhin kommt in der Praxis häufig vor, dass mehrere parallele Verbindungen oder Erdverbindungen bestehen. In diesen Fällen erfolgt eine Stromaufteilung oder Spannungsteilung abhängig von den jeweiligen Widerständen. Eine Phasenerkennung ist dann nicht mehr eindeutig möglich.

Die DE 10 2014 008750 A1 offenbart ein Verfahren zum Prüfen und Untersuchen von Verbindungszuständen und Leitungszuständen in einer Verdrahtung. Die US 3 441 842 A offenbart ein Verfahren zur Feststellung eines Ortes eines Kurzschlusses zwischen einem Leiterpaar in einem kurzgeschlossenen Stromkreis durch Zuführung eines oberwellenreichen Simulationssignals. Die US 2004/008018 A1 offenbart ein Verfahren zur Identifizierung von Elementen eines Schaltkreises oder zur Rückverfolgung eines Schaltkreises anhand eines Oberwellengehalts eines Erregungssignals.

ZUSAMMENFASSUNG DER ERFINDUNG

Es besteht ein Bedarf an verbesserten Möglichkeiten zum Prüfen einer Verdrahtung einer elektrischen Anlage mit mehreren Stromkreisen, welche schnell und zuverlässig mit einfachen Mitteln durchgeführt werden können.

Gemäß der vorliegenden Erfindung werden ein Verfahren zum Prüfen einer Verdrahtung einer elektrischen Anlage mit mehreren Stromkreisen und eine Prüfvorrichtung zum Prüfen einer Verdrahtung einer elektrischen Anlage mit mehreren Stromkreisen bereitgestellt, wie sie in den unabhängigen Ansprüchen definiert sind. Die abhängigen Ansprüche definieren Ausführungsformen der Erfindung.

Ein erfindungsgemäßes Verfahren zum Prüfen einer Verdrahtung einer elektrischen Anlage mit mehreren Stromkreisen umfasst ein Erzeugen mehrerer Prüfsignale. Jedes der mehreren Prüfsignale weist eine im Zeitbereich asymmetrische Signalform und eine Kombination von Harmonischen aus einer vorgegebenen Gruppe von höheren Harmonischen auf. Die im Zeitbereich asymmetrische Signalform kann für alle der mehreren Prüfsignale gleich sein.

Für diese Beschreibung gelten folgende Bezeichnungen. Eine Grundschwingung der Frequenz $f$ wird als erste Harmonische bezeichnet. Eine Schwingung der doppelten Frequenz $(2f)$ wird als zweite Harmonische bezeichnet. Allgemein ist die Schwingung mit der $n$-fachen Frequenz $nf$ die $n$-te Harmonische. Als höhere Harmonische werden alle Harmonischen außer der ersten Harmonischen bezeichnet. Höhere Harmonische werden auch als Oberschwingungen bezeichnet. Die $n$-te Harmonische wird dabei als die $(n-1)$-te Oberschwingung bezeichnet.

Die im Zeitbereich asymmetrische Signalform umfasst eine erste Harmonische (Grundschwingung). Die Signalform ist periodisch mit der Frequenz dieser Grundschwingung. Im Zeitbereich asymmetrisch bedeutet, dass die Signalform, die als Signalpegel über der Zeit aufgetragen wird, durch Spiegeln an einer Achse senkrecht zur Zeitachse nicht auf sich selbst abgebildet werden kann. Ein Beispiel für eine derartige im Zeitbereich asymmetrische Signalform ist die Kippschwingung oder Sägezahnschwingung mit beispielsweise einer steigenden Flanke mit kleiner Steigung und einer fallenden Flanke mit betragsmäßig großer (aber negativer) Steigung.

Die Kombinationen von Harmonischen der mehreren Prüfsignale sind unterschiedlich, d.h. jedes Prüfsignal besitzt eine eigene eindeutige Kombination von Harmonischen.

Beispielsweise kann jedes der mehreren Prüfsignale eine im Zeitbereich asymmetrische Signalform aufweisen, welche mittels einer Überlagerung einer ersten Harmonischen, einer zweiten Harmonischen und einer dritten Harmonischen mit jeweils entsprechenden Amplitudenfaktoren gebildet wird. Die im Zeitbereich asymmetrische Signalform umfasst in diesem Fall beispielsweise zusätzlich zu einer Grundschwingung zumindest eine zweite und dritte Harmonische. In einem anderen Beispiel kann die im Zeitbereich asymmetrische Signalform zusätzlich zu der Grundschwingung lediglich entweder die zweite oder die dritte Harmonische umfassen. Der so gebildeten im Zeitbereich asymmetrischen Signalform kann zusätzlich eine Kombination von weiteren höheren Harmonischen mit entsprechenden Amplitudenfaktoren überlagert werden, beispielsweise eine Kombination aus vierter Harmonischer und fünfter Harmonischer. Anders ausgedrückt umfasst in diesem Fall die vorgegebene Gruppe von höheren Harmonischen die vierte und die fünfte Harmonische. Eine erste Kombination, welche beispielsweise einem ersten Prüfsignale der mehreren Prüfsignale zugeordnet ist, kann eine vierte Harmonische und keine fünfte Harmonische aufweisen. Das erste Prüfsignal umfasst somit die erste, zweite, dritte und vierte Harmonische. Eine zweite Kombination, welche beispielsweise einem zweiten Prüfsignal der mehreren Prüfsignale zugeordnet ist, kann eine fünfte Harmonische, aber nicht die vierte Harmonische umfassen. Das zweite Prüfsignal umfasst somit die erste, zweite, dritte und fünfte Harmonische. Eine dritte Kombination, welche beispielsweise einem dritten Prüfsignal der mehreren Prüfsignale zugeordnet ist, kann weder die vierte noch die fünfte Harmonische aufweisen. Das dritte Prüfsignal umfasst somit lediglich die erste, zweite und dritte Harmonische.

Insgesamt ist beispielsweise die Kombination der Harmonischen der mehreren Prüfsignale derart ausgestaltet, dass auch beliebige Linearkombinationen der mehreren Prüfsignale im Wesentlichen die gleichen asymmetrischen Eigenschaften im Zeitbereich wie die einzelnen Prüfsignale aufweisen. Dies kann zum Beispiel erreicht werden, indem sich die Prüfsignale lediglich durch die höheren Harmonischen (z.B. der vierten und fünften Harmonischen) unterscheiden und bezüglich der Grundschwingung phasensynchron sind. Bei einer entsprechenden Kodierung der höheren Harmonischen (z.B. der vierten und fünften Harmonischen) kann auch erkannt werden, welche Einzelsignale in einem Summensignal, also der Linearkombination, vorkommen. Somit können die einzelnen Signale erkannt werden, aber auch beim Summensignal einfach festgestellt werden, aus welchen Teilsignalen es besteht.

Die so erzeugten mehreren Prüfsignale werden in mehrere erste Anschlüsse, die den mehreren Stromkreisen der elektrischen Anlage zugeordnet sind, an einer ersten Stelle der elektrischen Anlage eingespeist. Die mehreren Stromkreise können beispielsweise mehrere Phasen der elektrischen Anlage umfassen. In jeden ersten Anschluss der mehreren ersten Anschlüsse wird ein anderes Prüfsignal der mehreren Prüfsignale eingespeist. Anders ausgedrückt wird an der ersten Stelle in jeden Stromkreis der elektrischen Anlage ein anderes Prüfsignal eingespeist. An einer zweiten Stelle der elektrischen Anlage werden mehrere Messsignale an mehreren zweiten Anschlüssen, die den mehreren Stromkreisen zugeordnet sind, erfasst. Beispielsweise kann bei einem Umspannwerk die erste Stelle an einem Eingang des Umspannwerks sein und die zweite Stelle an einem der Ausgänge des Umspannwerks. In einem anderen Beispiel kann die erste Stelle an einer ersten Seite eines Transformators sein und die zweite Stelle an einer zweiten Seite des Transformators. Auf der Grundlage der eingespeisten Prüfsignale und der erfassten Messsignale wird eine Zuordnung zwischen jeweils einem ersten Anschluss der mehreren ersten Anschlüsse und einem zweiten Anschluss der mehreren zweiten Anschlüsse bestimmt, um beispielsweise abhängig von den Zuordnungen die Verdrahtung der elektrischen Anlage zu prüfen. Da die eingespeisten Prüfsignale unterschiedlich sind, kann eindeutig festgestellt werden, welches Prüfsignal an welchem der zweiten Anschlüsse zu einem entsprechenden Messsignal geführt hat, sodass eine eindeutige Zuordnung zwischen den ersten Anschlüssen und den zweiten Anschlüssen bestimmt werden kann. Beispielsweise können Vertauschungen, aber auch Unterbrechungen, auf einfache Art und Weise anhand der Prüfsignale festgestellt werden.

Beispielsweise kann im Falle eines Verdrahtungsfehlers eine Zuordnung ermittelt werden, die nicht einer gewünschten oder vorgegebenen Zuordnung entspricht, oder es ist keine oder keine vollständige Zuordnung möglich, zum Beispiel aufgrund von Unterbrechungen oder Kopplungen mit gänzlich falschen Stromkreisen. Im fehlerfreien Fall kann hingegen eine Zuordnung ermittelt werden, die einer vorgegebenen "Soll-Zuordnung" entspricht.

Durch das Vorhandensein oder Nichtvorhandensein einer bestimmten Harmonischen, beispielsweise der vierten oder fünften Harmonischen, erfolgt somit eine Art digitaler Kodierung der Prüfsignale. Durch Hinzuziehen der sechsten Harmonischen kann die Anzahl der unterschiedlichen Kombinationen und somit die Anzahl der unterschiedlichen Prüfsignale erhöht werden, um beispielsweise Prüfsignale zum Prüfen einer Verdrahtung einer elektrischen Anlage mit mehr als drei Phasen oder Stromkreisen zu ermöglichen, beispielsweise zum Prüfen von zwei dreiphasigen Anlagenteilen, also insgesamt sechs Phasen, oder Anlagenteilen mit mehreren Stromkreisen, beispielsweise mit sechs oder mehr Stromkreisen.

Die mehreren Prüfsignale können gleichzeitig in die mehreren ersten Anschlüsse eingespeist werden. Ebenso können die mehreren Messsignale gleichzeitig erfasst werden. Durch die Kodierung der Prüfsignale aufgrund der unterschiedlichen Kombinationen von enthaltenen Harmonischen, können die mehreren Messsignale, welche an der zweiten Stelle der elektrischen Anlage erfasst werden, den entsprechenden Prüfsignalen eindeutig zugeordnet werden, auch wenn die Prüfsignale gleichzeitig durch die elektrische Anlage geleitet werden. Eine entsprechende Messverkabelung zum Einspeisen der Prüfsignale und zum Erfassen der Messsignale kann daher zu einem Zeitpunkt erfolgen und die Verdrahtung überprüft werden, ohne die Messverkabelung zu ändern. Dadurch kann die Prüfung der Verdrahtung schnell durchgeführt werden. Verkabelungsfehler können vermieden werden, da die Messverkabelung nicht geändert werden muss, um die Verdrahtung aller Stromkreise und/oder Phasen zu überprüfen.

Gemäß einer Ausführungsform weist die erste Harmonische, also die Grundschwingung, der im Zeitbereich asymmetrischen Signalform eine Frequenz auf, welche ungleich einer Netzfrequenz oder Nominalfrequenz der elektrischen Anlage ist. Die erste Harmonische der im Zeitbereich asymmetrischen Signalform kann beispielsweise eine Frequenz im Bereich von 50 bis 60 Hz aufweisen, insbesondere eine Frequenz im Bereich von 51 bis 55 Hz, beispielsweise eine Frequenz von 52,63 Hz. Indem die erste Harmonische der Prüfsignale ungleich der Netzfrequenz der elektrischen Anlage ist, können Störungen von anderen in Betrieb befindlichen Anlagenteilen vermieden werden. In Betrieb befindliche Anlagenteile erzeugen üblicherweise Störsignale bei Netzfrequenz, also beispielsweise bei 50 Hz oder 60 Hz, sowie Störsignale mit höheren Harmonischen davon. Wenn die Grundschwingung und die höheren Harmonischen der Prüfsignale von dieser Netzfrequenz und den entsprechenden höheren Harmonischen abweichen, können die Störsignale von anderen in Betrieb befindlichen Anlagenteilen auf einfache Art und Weise in den Messsignalen erkannt und herausgefiltert werden. Da die Grundschwingung der im Zeitbereich asymmetrischen Signalform eine Frequenz hat, die nicht sehr stark von der Nominalfrequenz der elektrischen Anlage abweicht, sind die Prüfsignale für eine Übertragung über die elektrische Anlage geeignet, beispielsweise über Strom- oder Spannungswandler mit Transformatoren und/oder Kapazitäten.

Bei einer Ausführungsform weist eine Amplitude einer n-ten Harmonischen der Gruppe von höheren Harmonischen einen Amplitudenfaktor von $1/n^2$ bezogen auf eine Amplitude einer Grundschwingung der im Zeitbereich asymmetrischen Signalform auf. Auch die oben beschriebenen zweiten und dritten Harmonischen können einen entsprechenden Amplitudenfaktor aufweisen. Mit derartigen Amplitudenfaktoren kann die im Zeitbereich asymmetrische Signalform erreicht werden. Signalformen, welche die erste bis dritte Harmonische und eine Kombination von weiteren höheren Harmonischen, beispielsweise vierten und/oder fünften und/oder sechsten Harmonischen, umfassen, weisen beispielsweise eine Sägezahn ähnliche Signalform mit einer steilen steigenden Flanke und einer flachen fallenden Flanke auf, sodass Signalform im Zeitbereich asymmetrische ist. Ferner haben die so erzeugten Prüfsignale im Wesentlichen im Mittel keinen Gleichanteil, sodass eine Sättigung von Strom- oder Spannungswandlern in der elektrischen Anlage vermieden werden kann.

Gemäß einer Ausführungsform werden die Zuordnungen bestimmt, indem die Messsignale mit Bandpassfiltern gefiltert werden, deren Mittenfrequenzen den Frequenzen der Harmonischen aus der vorgegebenen Gruppe von höheren Harmonischen entsprechen. Die gefilterten Messsignale werden mit einem Schwellenwert verglichen. Der Schwellenwert kann in Abhängigkeit von einer Amplitude einer Grundschwingung der im Zeitbereich asymmetrischen Signalform eingestellt werden. Da die Harmonischen des Prüfsignals in der elektrischen Anlage normalerweise nicht vorkommen, kann der Schwellenwert verhältnismäßig gering eingestellt werden, zum Beispiel auf ein Prozent der Grundschwingung, sodass auch noch schwache Signale eindeutig zugeordnet werden können. Mit der oben beschriebenen Kodierung der Prüfsignale kann eine Zuordnung zwischen Messsignalen und Prüfsignalen, also zwischen ersten Anschlüssen und zweiten Anschlüssen, verhältnismäßig einfach über das Überprüfen auf Vorhandensein eines Signalpegels an Ausgängen der Bandpassfilter durchgeführt werden.

Bei einer weiteren Ausführungsform werden die Zuordnungen bestimmt, indem in den Messsignalen Amplituden von den Frequenzen bestimmt werden, die den Frequenzen der Harmonischen aus der vorgegebenen Gruppe von höheren Harmonischen entsprechen. Diese Amplituden können beispielsweise mittels einer diskreten FourierTransformation bestimmt werden. Die so bestimmten Amplituden werden jeweils mit einem Schwellenwert verglichen. Wie in der vorherigen Ausführungsform beschrieben, kann der Schwellenwert verhältnismäßig gering eingestellt werden, beispielsweise auf ein Prozent der Grundschwingung, sodass auch kleine Amplituden eindeutig erkannt werden können. Mit der oben beschriebenen Kodierung der Prüfsignale kann eine Zuordnung zwischen Messsignalen und Prüfsignalen, also zwischen ersten Anschlüssen und zweiten Anschlüssen, verhältnismäßig einfach über das Überprüfen auf Vorhandensein eines Signalpegels bei Frequenzen der entsprechenden Harmonischen durchgeführt werden.

Die Kodierung von Prüfsignalen durch Hinzufügen einer Kombination von höheren Harmonischen zu der im Zeitbereich asymmetrischen Signalform wird nachfolgend in Form von drei Ausführungsformen im Detail beschrieben werden.

Bei einer Ausführungsform umfasst die vorgegebene Gruppe von höheren Harmonischen eine vierte Harmonische und eine fünfte Harmonische. Die Kombinationen für die verschiedenen Prüfsignale werden, wie bereits weiter oben beschrieben, folgendermaßen gewählt: eine erste Kombination umfasst die vierte Harmonische, aber nicht die fünfte Harmonische. Eine entsprechende digitale Darstellung dieser Kombination kann mit 10 bezeichnet werden, wobei die erste Stelle das Vorhandensein (1) bzw. das Nichtvorhandensein (0) der vierten Harmonischen und die zweite Stelle das Vorhandensein (1) bzw. das Nichtvorhandensein (0) der fünften Harmonischen darstellt. Eine zweite Kombination umfasst die fünfte Harmonische, aber nicht die vierte Harmonische. Die entsprechende digitale Darstellung dieser Kombination ist 01. Eine dritte Kombination umfasst weder die vierte noch die fünfte Harmonische und die entsprechende digitale Darstellung dieser Kombination ist 00. Mit einer Kombination von lediglich zwei Harmonischen können daher ausreichend viele Prüfsignale für ein Prüfen einer elektrischen Anlage mit drei Phasen bereitgestellt werden.

Bei einer weiteren Ausführungsform umfasst die vorgegebene Gruppe von höheren Harmonischen neben der vierten und fünften Harmonischen auch eine sechste Harmonische. Kombinationen für die verschiedenen Prüfsignale können folgendermaßen gewählt werden, wobei zur Vereinfachung lediglich die entsprechende digitale Darstellung dieser Kombinationen aufgelistet werden. Bei dieser digitalen Darstellung bezeichnet die erste Stelle das Vorhandensein (1) bzw. das Nichtvorhandensein (0) der vierten Harmonischen, die zweite Stelle das Vorhandensein (1) bzw. Nichtvorhandensein (0) der fünften Harmonischen und die dritte Stelle das Vorhandensein (1) bzw. Nichtvorhandensein (0) der sechsten Harmonischen. Eine erste Kombination lautet beispielsweise 100, eine zweite Kombination beispielsweise 010 und eine dritte Kombination beispielsweise 001. Mit diesen Kombinationen können ausreichend viele Prüfsignale für ein Prüfen einer elektrischen Anlage mit drei Phasen bereitgestellt werden, wobei die Hamming-Distanz der drei Kombinationen zwei beträgt, sodass eine Erkennung der Kombinationen auch bei verrauschten oder gestörten Signalen zuverlässig möglich ist.

Bei noch einer weiteren Ausführungsform umfasst die vorgegebene Gruppe von höheren Harmonischen die vierte, fünfte und sechste Harmonische. Kombinationen für die verschiedenen Prüfsignale können folgendermaßen gewählt werden, wobei zur Vereinfachung wiederum lediglich die entsprechende digitale Darstellung dieser Kombinationen aufgelistet werden. Eine erste Kombination lautet beispielsweise 001, eine zweite Kombination beispielsweise 010, eine dritte Kombination beispielsweise 011, eine vierte Kombination beispielsweise 100, eine fünfte Kombination beispielsweise 101 und eine sechste Kombination beispielsweise 110. Mit diesen Kombinationen können ausreichend viele Prüfsignale für ein Prüfen einer elektrischen Anlage mit zwei mal drei Phasen oder bis zu acht Stromkreisen bereitgestellt werden.

Bei einer weiteren Ausführungsform umfasst die vorgegebene Gruppe von höheren Harmonischen zusätzlich Amplitudenfaktoren, welche den höheren Harmonischen zugeordnet werden können. Eine dem jeweiligen Prüfsignal zugeordnete eindeutige Kombination von Harmonischen kann zusätzlich ein oder mehrere Amplitudenfaktoren aus der vorgegebenen Gruppe umfassen. Beispielsweise kann eine erste Kombination eine bestimmte höhere Harmonische, beispielsweise die vierte Harmonische, mit einem ersten Amplitudenfaktor aufweisen, beispielsweise mit dem Amplitudenfaktor 1/16. Eine zweite Kombination der unterschiedlichen Kombinationen kann die gleiche höhere Harmonische, also die vierte Harmonische, mit einem zweiten Amplitudenfaktor aufweisen, beispielsweise dem Amplitudenfaktor 1/24. Eine dritte Kombination der unterschiedlichen Kombinationen kann die gleiche höhere Harmonische, also die vierte Harmonische, mit einem dritten Amplitudenfaktor aufweisen, beispielsweise dem Amplitudenfaktor 1/48. Zu beachten ist, dass die Amplitudenfaktoren, im Beispiel also der erste, zweite und dritte Amplitudenfaktor, unterschiedlich sind. Weitere Kombinationen können beispielsweise auf einer anderen höheren Harmonischen, beispielsweise der fünften Harmonischen, basieren. Bei entsprechender Kodierung können Phasen mehrerer Mehrphasensystem, beispielsweise mehrerer Dreiphasensysteme, oder mehrere Stromkreise voneinander unterschieden und somit deren Verdrahtungen gleichzeitig geprüft werden.

Gemäß einer weiteren Ausführungsform umfasst das Verfahren weiterhin ein Bestimmen von Polaritäten der erfassten Messsignale, um abhängig von den bestimmten Polaritäten die Verdrahtung der elektrischen Anlage zu prüfen. Insbesondere die asymmetrische Signalform der Prüfsignale im Zeitbereich kann eine einfache und zuverlässige Bestimmung der Polarität ermöglichen. Wenn beispielsweise die Verdrahtung eines Transformators fehlerhaft ist, zum Beispiel wenn Anschlüsse an einer Seite des Transformators vertauscht wurden, kann das Messsignal eine gegenüber dem entsprechenden Prüfsignale entgegengesetzte Polarität aufweisen. Bei einer im Zeitbereich asymmetrischen Signalform kann die entgegengesetzte Polarität leicht erkannt werden. Hat beispielsweise das Prüfsignal eine steile steigende Flanke und eine flache fallende Flanke, hat ein Messsignal mit entgegengesetzter Polarität eine flache steigende Flanke und eine steile fallende Flanke. Ein entsprechender Fehler in der Verdrahtung kann somit festgestellt werden.

Zum Bestimmen von Polaritäten der erfassten Messsignale kann beispielsweise für ein jeweiliges Messsignalen der erfassten Messsignale eine Ableitung des Messsignals bestimmt werden und ein Vergleichssignal durch vergleich der Ableitung mit einem Schwellenwert erzeugt werden. Das Vergleichssignal kann beispielsweise einen positiven Wert für Bereiche der Ableitung mit positiver Steigung über dem Schwellenwert und einen betragsmäßig gleichen negativen Wert für Bereiche der Ableitung mit negativer Steigung über dem Schwellenwert aufweisen. Wird dann der Mittelwert des Vergleichssignals bestimmt, beispielsweise als gleitender Mittelwert oder über eine Periode der Grundschwingung des Prüfsignals, kann die Polarität des Messsignals in Abhängigkeit von dem Mittelwert des Vergleichssignals bestimmt werden.

Alternativ oder zusätzlich kann das Bestimmen von Polaritäten der erfassten Messsignale für ein jeweiliges Messsignalen ein Bestimmen eines Korrelationskoeffizienten, insbesondere eines Korrelationsfaktors, in Abhängigkeit von dem jeweiligen Messsignal und der im Zeitbereich asymmetrischen Signalform umfassen. Die Polarität des jeweiligen Messsignals kann in Abhängigkeit von dem Korrelationsfaktor bestimmt werden. Bei gleicher Polarität ist der Korrelationsfaktor positiv und hat beispielsweise einen Wert nahe 1. Bei entgegengesetzter Polarität ist der Korrelationsfaktor negativ und hat beispielsweise einen Wert nahe -1.

Eine erfindungsgemäße Prüfvorrichtung zum Prüfen einer Verdrahtung einer elektrischen Anlage mit mehreren Stromkreisen umfasst eine Prüfsignalerzeugungsvorrichtung, eine Einspeisevorrichtungen, eine Erfassungsvorrichtung und eine Verarbeitungsvorrichtung. Die Prüfsignalerzeugungsvorrichtung ist ausgestaltet, mehrere Prüfsignale zu erzeugen. Jedes der mehreren Prüfsignale weist eine im Zeitbereich asymmetrische Signalform und eine Kombination von Harmonischen aus einer vorgegebenen Gruppe von höheren Harmonischen auf. Die Kombinationen von Harmonischen der mehreren Prüfsignale sind unterschiedlich. Die Einspeisevorrichtung ist ausgestaltet, an einer ersten Stelle der elektrischen Anlage die mehreren Prüfsignale in mehrere erste Anschlüsse einzuspeisen. Die mehreren ersten Anschlüsse sind den mehreren Stromkreisen der elektrischen Anlage zugeordnet. In jeden ersten Anschluss der mehreren ersten Anschlüsse wird ein anderes Prüfsignal der mehreren Prüfsignale eingespeist. Da die Prüfsignale auf unterschiedlichen Kombinationen von Harmonischen beruhen, sind die an der ersten Stelle in die mehreren ersten Anschlüsse eingespeisten Prüfsignale unterschiedlich. Die Erfassungsvorrichtung ist ausgestaltet, an einer zweiten Stelle der elektrischen Anlage mehrere Messsignale an mehreren zweiten Anschlüssen, die den mehreren Stromkreisen zugeordnet sind, zu erfassen. Die erste Stelle und die zweite Stelle sind unterschiedliche Stellen der elektrischen Anlage. Die mehreren Stromkreise können beispielsweise mehrere Phasen der elektrischen Anlage umfassen. Beispielsweise kann die erste Stelle an einer Seite eines Transformators der elektrischen Anlage sein und die zweite Stelle an der anderen Seite des Transformators. Die Erfassungsvorrichtung ist ausgestaltet, Zuordnungen zwischen jeweils einem ersten Anschluss der mehreren ersten Anschlüsse und einem zweiten Anschluss der mehreren zweiten Anschlüsse auf der Grundlage der eingespeisten Prüfsignale und der erfassten Messsignale zu bestimmen.

Die Prüfsignalerzeugungsvorrichtung kann mehrere einphasige Geräte umfassen, die jeweils nur ein Prüfsignal erzeugen. Die mehreren einphasigen Geräte können so konfiguriert werden, dass sie jeweils eines der mehreren Prüfsignale erzeugen, die auf unterschiedlichen Kombinationen von Harmonischen beruhen. Alternativ oder zusätzlich kann die Prüfsignalerzeugungsvorrichtung mehrere mehrphasige Geräte umfassen, zum Beispiel zwei dreiphasige Geräte, um sechs Prüfsignale erzeugen , mit denen sechs Stromkreise oder Phasen gleichzeitig geprüft werden können. Die Geräte können dabei in Verbindung stehen sein, um die gleiche Phasenlage zu erreichen, was die Erkennung von überlagerten Signalen vereinfacht. Die Erkennung der einzelnen Phasen funktioniert aber auch, wenn die Geräte nicht gekoppelt sind.

Die Prüfvorrichtung kann insbesondere zur Durchführung des zuvor beschriebenen Verfahrens oder einer seiner Ausführungsformen ausgestaltet sein und umfasst daher auch die im Zusammenhang mit dem Verfahren zuvor beschriebenen Vorteile.

KURZE BESCHREIBUNG DER FIGUREN

Die Erfindung wird nachfolgend unter Bezugnahme auf die Zeichnungen anhand von Ausführungsformen näher erläutert. In den Zeichnungen bezeichnen identische Bezugszeichen identische Elemente.

Fig. 1 zeigt schematisch eine Prüfvorrichtung zum Prüfen einer Verdrahtung einer elektrischen Anlage mit mehreren Phasen gemäß einer Ausführungsform.

Fig. 2 zeigt ein Verfahren zum Prüfen einer Verdrahtung einer elektrischen Anlage mit mehreren Phasen gemäß einer Ausführungsform.

Fig. 3 zeigt schematisch mehrere Prüfsignale gemäß einer Ausführungsform, die eine im Zeitbereich asymmetrische Signalform und eine Kombination von höheren Harmonischen aufweisen.

Fig. 4 zeigt schematisch Ableitungen der mehreren Prüfsignale der Fig. 3 nach der Zeit.

Fig. 5 zeigt schematisch ein Vergleichssignal, welches durch Vergleichen einer Ableitung eines Prüfsignals mit einem Schwellenwert gebildet wird.

Fig. 6 zeigt schematisch eine weitere Prüfvorrichtung zum Prüfen einer Verdrahtung einer elektrischen Anlage mit mehreren Stromkreisen gemäß einer Ausführungsform.

DETAILLIERTE BESCHREIBUNG VON AUSFÜHRUNGSBEISPIELEN

Nachfolgend wird die vorliegende Erfindung anhand von Ausführungsformen unter Bezugnahme auf die Figuren näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können als direkte oder indirekte Verbindungen oder Kopplungen implementiert werden. Eine Verbindung oder Kopplung kann drahtgebunden oder drahtlos implementiert sein.

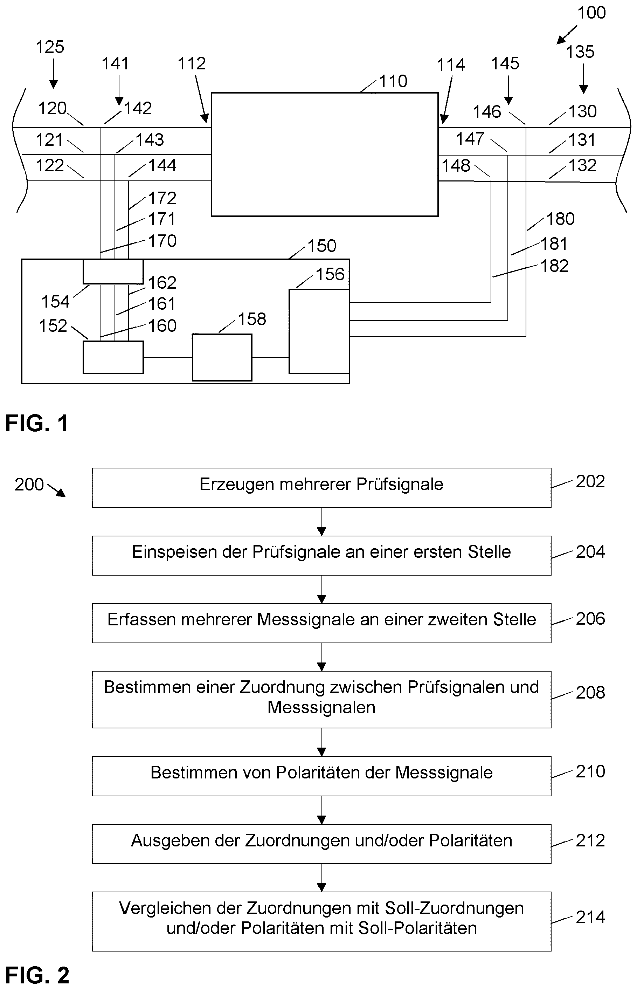

Fig. 1 zeigt schematisch einen Ausschnitt einer elektrischen Anlage 100, an welche eine Prüfvorrichtung 150 zum Prüfen einer Verdrahtung der elektrischen Anlage 100 angeschlossen ist. Die elektrische Anlage 100 ist eine mehrphasige elektrische Anlage. Viele energietechnische Systeme verwenden ein drei Phasen Drehstromsystem. In dem in Fig. 1 gezeigten Beispiel ist die elektrische Anlage 100 eine dreiphasige Anlage. Die elektrische Anlage 100 kann beispielsweise eine Hochspannungsanlage oder einen Teil davon umfassen. Die elektrische Anlage 100 umfasst eine elektrische Komponente 110, an welcher zwei dreiphasige Anschlüsse vorgesehen sind. Die elektrische Komponente 110 kann beispielsweise einen dreiphasigen Leistungsschalter, einen dreiphasigen Transformator, mehrere Transformatoren, Kapazitäten, Strom- und Spannungswandler oder Zwischenwandler aufweisen. An einer ersten Seite 112 weist die elektrische Komponente 110 Anschlüsse auf, die mit Außenleitern 120 bis 122 einer dreiphasigen Stromleitung 125 verbunden sind. An einer zweiten Seite 114 weist die elektrische Komponente 110 Anschlüsse auf, die mit Außenleitern 130 bis 132 einer zweiten dreiphasigen Stromleitung 135 verbunden sind. Die elektrische Komponente 110 kann weitere Anschlüsse aufweisen, beispielsweise für eine Erdung oder für einen Neutralleiter eines Dreiphasensystems in Sternschaltung, wobei jedoch diese weiteren Anschlüsse aus Gründen der Übersichtlichkeit nicht gezeigt sind. Bei einer Installation der elektrischen Komponente 110 können Verdrahtungsfehler auftreten. Beispielsweise können zwei Außenleiter, beispielsweise die Außenleiter 120 und 121, an der ersten Seite 112 der elektrischen Komponente 110 vertauscht angeschlossen sein. Nach einer Installation oder Reparatur an der elektrischen Anlage 100 kann es daher erforderlich sein, die Verdrahtung zu überprüfen.

Um die Verdrahtung zu überprüfen, kann die in Fig. 1 gezeigte Prüfvorrichtung 150 elektrisch mit beiden Seiten 112, 114 der elektrischen Komponente 110 gekoppelt werden.

Die Prüfvorrichtung 150 umfasst eine Prüfsignalerzeugungsvorrichtung 152, welche mehrere Prüfsignale erzeugt. Für eine Prüfung der dreiphasigen elektrischen Anlage 100 erzeugt die Prüfsignalerzeugungsvorrichtung 152 beispielsweise drei Prüfsignale 160 bis 162. Die Prüfvorrichtung 150 umfasst weiterhin eine Einspeisevorrichtung 154, mit welcher die Prüfsignale 160 bis 162 über entsprechende Leitungen 170 bis 172 an einer ersten Stelle 141 der elektrischen Anlage 100 in mehrere erste Anschlüsse 142 bis 144 eingespeist werden. Die Einspeisevorrichtung 154 kann beispielsweise die Prüfsignale von der Prüfsignalerzeugungsvorrichtung 152 an einen Nominalbereich der elektrischen Komponente 110 anpassen und an drei Anschlüssen bereitstellen. An die drei Anschlüsse der Einspeisevorrichtung 154 kann eine Leitungsgarnitur angeschlossen werden, welche die drei Leitungen 170 bis 172 umfasst. An der ersten Stelle 141, beispielsweise einer verhältnismäßig leicht zugänglichen Verteilung vor der elektrischen Komponente 110, kann die Leitung 170 an den Außenleiter 120 angeschlossen werden, sodass ein erstes Prüfsignal in den Außenleiter 120 eingespeist wird. Die Leitung 171 kann an den Außenleiter 121 angeschlossen werden, um ein zweites Prüfsignal in den Außenleiter 121 einzuspeisen. Die Leitung 172 kann an den Außenleiter 122 angeschlossen werden, um ein drittes Prüfsignal in den Außenleiter 122 einzuspeisen. Somit wird in jede Phase auf der ersten Seite 112 der Komponente 110 ein entsprechendes Prüfsignal eingespeist.

Die Prüfvorrichtung 150 umfasst weiterhin eine Erfassungsvorrichtung 156, welche über entsprechende Leitungen 180 bis 182 mit den drei Außenleitern 130 bis 132, welche mit der zweiten Seite 114 der Komponente 110 verbunden sind, an einer zweiten Stelle 145 der elektrischen Anlage 100 über entsprechende zweite Anschlüsse 146 bis 148 verbunden ist. Die zweite Stelle 145 kann sich an einer leicht zugänglichen Verteilung der elektrischen Anlage 100 befinden. Somit kann für jede Phase auf der zweiten Seite 114 ein entsprechendes Messsignal erfasst werden.

Die Prüfvorrichtung 150 umfasst weiterhin eine Verarbeitungsvorrichtung 158. Die Verarbeitungsvorrichtung 158 umfasst beispielsweise eine elektronische Steuerung, beispielsweise eine Mikroprozessorsteuerung, welche beispielsweise ein Computerprogramm ausführen kann. Die Verarbeitungsvorrichtung 158 kann mit der Prüfsignalerzeugungsvorrichtung 152 und der Erfassungsvorrichtung 156 gekoppelt sein, um diese in einer koordinierten Art und Weise anzusteuern, wie es nachfolgend im Detail beschrieben werden wird. In anderen Beispielen ist die Verarbeitungsvorrichtung 158 nicht mit der Prüfsignalerzeugungsvorrichtung 152 verbunden und die Prüfsignalerzeugungsvorrichtung 152 erzeugt die Prüfsignale unabhängig von einer Steuerung durch die Verarbeitungsvorrichtung 158. Somit ist klar, dass die Prüfsignalerzeugungsvorrichtung 152, die Einspeisevorrichtung 154, die Erfassungsvorrichtung 156 und die Verarbeitungsvorrichtung 158 nicht notwendigerweise in ein und demselben Gehäuse oder in einer Einheit ausgebildet sein müssen, sondern räumlich unabhängige Einheiten mit eigenen Gehäusen umfassen können. Beispielsweise kann die Prüfsignalerzeugungsvorrichtung 152 zusammen mit der Einspeisevorrichtung 154 eine Einheit bilden, welche unabhängig von einer weiteren Einheit betrieben und aufgestellt werden kann, welche die Erfassungsvorrichtung 156 und die Verarbeitungsvorrichtung 158 umfasst. Dadurch kann auch bei großen elektrischen Anlagen, bei denen die erste Stelle 141 räumlich weit von der zweiten Stelle 145 entfernt ist, die Prüfvorrichtung 150 verwendet werden, ohne dass entsprechend lange Leitungen 170 bis 172 bzw. 180 bis 182 erforderlich sind.

Die Arbeitsweise der Prüfvorrichtung 150 wird nachfolgend unter Bezugnahme auf die Figuren 2 bis 5 im Detail beschrieben werden. Fig. 2 zeigt ein Verfahren 200 mit Verfahrensschritten 202 bis 214, welche von der Prüfvorrichtung 150 ausgeführt werden können, um die Verdrahtung der elektrischen Anlage 100 zu prüfen. Zumindest einige der in Fig. 2 gezeigten Verarbeitungsschritte können insbesondere mit der Verarbeitungsvorrichtung 158 durchgeführt werden, beispielsweise mittels eines Computerprogramms, welches von der Verarbeitungsvorrichtung 158 ausgeführt wird.

Im Schritt 202 werden mehrere Prüfsignale erzeugt. Im Detail wird für jede Phase ein eigenes Prüfsignal $P_p(t)$ erzeugt, welches eine im Zeitbereich asymmetrische Signalform und eine Kombination von Harmonischen aus einer vorgegebenen Gruppe von höheren Harmonischen aufweist. Der Index $p$ bezeichnet die Phase, für die das Prüfsignal $P_p(t)$ vorgesehen ist. Die Kombinationen von Harmonischen der mehreren Prüfsignale sind unterschiedlich, sodass die Prüfsignale auch unterschiedlich sind. Beispielsweise können die Prüfsignale auf einem gemeinsamen Signal $P(t)$ basieren, welches eine im Zeitbereich asymmetrische Signalform hat. Die Signalform des gemeinsamen Signals $P(t)$ kann einer Sägezahnsignalform angenähert sein. Dazu können beispielsweise Sinussignale mit verschiedener Amplitude und Frequenz verwendet werden, welche mittels Fourier-Synthese die Sägezahnsignalform annähernd nachbilden. Beispielsweise kann als gemeinsames Signal $P(t)$ ein Signal gemäß folgender Gleichung verwendet werden:

$$P(t) = A \sum_{n=1}^{k} \frac{1}{n^2} \sin\left(2\pi n f_g t\right)$$

A stellt hier die Amplitude des gesamten Signals dar, k die Anzahl der verwendeten Harmonischen und $f_g$ die Grundfrequenz des Signals. Der Term $\frac{1}{n^2}$ gewichtet die einzelnen Sinusfunktionen, um in Summe die Sägezahnsignalform anzunähern.

Beispielsweise kann ein Signal mit $A = 1$, $k = 3$ und $f_g = 52{,}63$ Hz gebildet werden. In anderen Beispielen kann $A$ auch so gewählt werden, dass ein Effektivwert (RMS) des Signals annähernd 1 beträgt. Beispielsweise kann $A \sim 0{,}962$ gewählt werden.

Jedes der Prüfsignale $P_p(t)$ umfasst weitere höhere Harmonische. Beispielsweise umfasst das Prüfsignal $P_1(t)$ für eine erste Phase zusätzlich die vierte Harmonische, das Prüfsignal $P_2(t)$ für eine zweite Phase zusätzlich die fünfte Harmonische, wohingegen das Prüfsignal $P_3(t)$ für eine dritte Phase weder die vierte noch die fünfte Harmonische umfasst. Insgesamt ergeben sich für ein drei Phasen System die Prüfsignale beispielsweise gemäß folgender Gleichung und Tabelle:

$$P_p(t) = A \sum_{n=1}^{k} H_n(p) \sin\left(2\pi n f_g t\right)$$

| Signal | Harmonische $H_n(p)$ | | | | |
|--------|------|------|--------|--------|------|
| $n$ | 1 | 2 | 3 | 4 | 5 |
| $P_1(t)$ | 1,0 | 0,25 | 0,111... | 0,0625 | 0,0 |
| $P_2(t)$ | 1,0 | 0,25 | 0,111... | 0,0 | 0,04 |
| $P_3(t)$ | 1,0 | 0,25 | 0,111... | 0,0 | 0,0 |

In diesem Fall wurde im Prinzip eine binäre Darstellung der Phasennummer $p$ verwendet und die Amplituden der vierten und fünften Harmonischen entsprechend angepasst bzw. codiert:

| Phase $p$ | Binäre Darstellung | $H_4(p)$ | $H_5(p)$ |
|-----------|-------------------|----------|----------|
| 1 | 10 | $\frac{1}{4^2}$ (unverändert) | 0,0 (entfernt) |
| 2 | 01 | 0,0 (entfernt) | $\frac{1}{5^2}$ (unverändert) |
| 3 | 00 | 0,0 (entfernt) | 0,0 (entfernt) |

Die Prüfsignale haben eine im Zeitbereich asymmetrische Signalform, wodurch, wie später beschrieben werden wird, die Polarität unterschieden werden kann. Die Grundfrequenz der Prüfsignale kann so gewählt werden, dass ein zeitlich variables Signal entsteht, welches über Strom- oder Spannungswandler der Anlage 100 übertragen werden kann, beispielsweise über Transformatoren und/oder Kapazitäten. Ferner haben die Prüfsignale im Wesentlichen keinen Gleichanteil, wodurch eine Sättigung von Strom- oder Spannungswandlern vermieden werden kann. Die Grundfrequenz der Prüfsignale kann so gewählt werden, dass sie in einem günstigen Übertragungsbereich der Strom- oder Spannungswandler sind. Beispielsweise kann die Grundfrequenz nahe der Nominalfrequenz der Wandler, also nahe der Netzfrequenz liegen. Andererseits sollte die Grundfrequenz des Prüfsignals möglichst nicht mit der Grundfrequenz oder Harmonischen der verwendeten Netzfrequenz oder anderer im energietechnischen System vorkommenden Frequenzen übereinstimmen, um eine möglichst gute Trennung zwischen Prüfsignalen und Störungen zu ermöglichen. Die oben genannte Grundfrequenz von 52,63 Hz erfüllt beispielsweise diese Anforderungen für Anlagen mit 50 Hz oder 60 Hz Nominalfrequenz, wie aus der nachfolgenden Tabelle ersichtlich ist.

| | Grundfrequenz | 2. Harm. | 3. Harm. | 4. Harm. | 5. Harm. |
|--|--------------|----------|----------|----------|----------|
| Prüfsignal | 52,63 Hz | 105,26 | 157,89 Hz | 210,52 Hz | 263,15 Hz |
| 50 Hz Netz | 50,00 Hz | 100,00 Hz | 150,00 Hz | 200,00 Hz | 250,00 Hz |
| 60 Hz Netz | 60,00 Hz | 120,00 Hz | 180,00 Hz | 240,00 Hz | 300,00 Hz |

Andere Frequenzen größer als 50 Hz und kleiner als 60 Hz können jedoch ebenso verwendet werden.

Durch die verhältnismäßig kleinen Amplituden der vierten und/oder fünften Harmonischen ändert sich die asymmetrische Signalform nur unwesentlich. Niedrigere Harmonische, wie beispielsweise die zweite und dritte Harmonische, eignen sich weniger für eine Kodierung der Phase, da sie die Asymmetrie des Signals im Zeitbereich wesentlich beeinflussen und daher eine Erkennung, insbesondere der Polarität, erschweren könnten. Noch höhere Harmonische, insbesondere siebte oder höhere Harmonische, sind ebenfalls weniger geeignet, da Strom- und Spannungswandler üblicherweise hohe Frequenzen wesentlich stärker dämpfen und somit die Übertragung und Erkennung beeinträchtigen könnten.

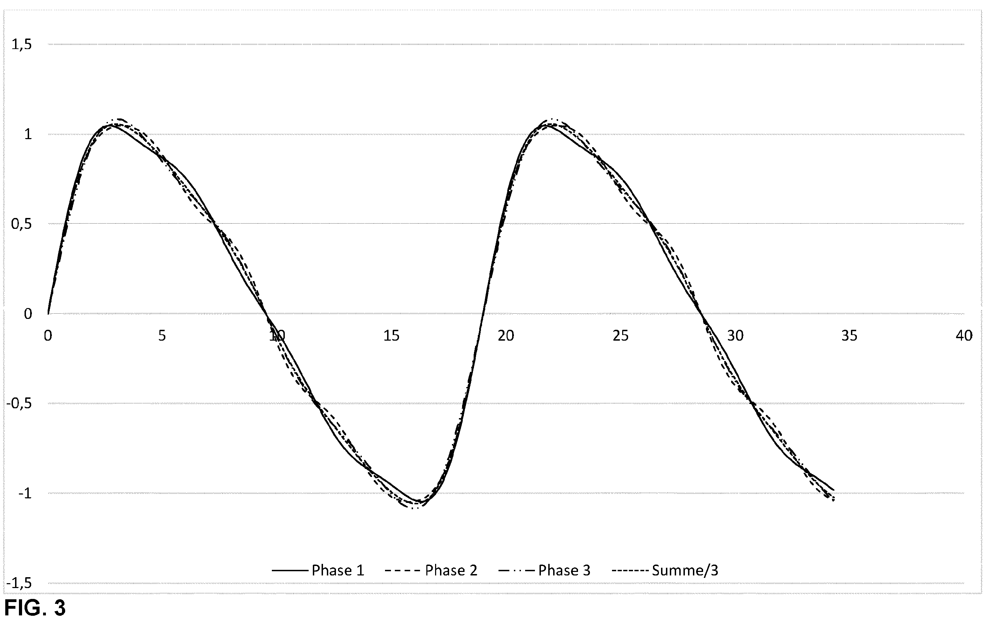

Fig. 3 zeigt Signalformen der Prüfsignale für die Phasen 1, 2 und 3 sowie ein durch drei geteiltes Summensignal der Prüfsignale für die Phasen 1, 2 und 3. Wie aus der Fig. 3 ersichtlich ist, ist die asymmetrische Signalform im Zeitbereich bei allen Prüfsignalen und auch beim Summensignal deutlich zu erkennen, das heißt, die Signale haben alle im Wesentlichen eine verhältnismäßig steile steigende Flanke und eine verglichen mit der steigenden Flanke verhältnismäßig flache fallende Flanke.

Im Schritt 204 werden die erzeugten Prüfsignale 160 bis 162 an der ersten Stelle 141 über die ersten Anschlüsse 142 bis 144 in die Außenleiter 120 bis 122 eingespeist. Die Prüfsignale 160 bis 162 können gleichzeitig eingespeist werden. Die so eingespeisten Prüfsignale laufen durch die elektrische Komponente 110, die beispielsweise ein oder mehrere Transformatoren oder Kapazitäten oder sonstige elektrotechnische Einrichtungen, wie zum Beispiel Leistungsschalter umfasst. An der zweiten Seite 114 gibt die elektrische Komponente 110 aufgrund der eingespeisten Prüfsignale Ausgangssignale auf den drei Außenleitern 130 bis 132 aus. Bei einer richtig angeschlossenen elektrischen Komponente 110 wird beispielsweise erwartet, dass das Prüfsignal, welches auf dem Außenleiter 120 eingespeist wurde, im Wesentlichen auf dem Außenleiter 130 ausgegeben wird, beispielsweise mit veränderter Spannung im Falle eines Transformators. Die Signalform wäre jedoch erwartungsgemäß im Wesentlichen unverändert. Ebenso wird bei richtig angeschlossener elektrischer Komponente 110 beispielsweise erwartet, dass das in den Außenleiter 121 eingespeiste Signal im Wesentlichen auf den Außenleiter 131 ausgegeben wird und das in den Außenleiter 122 eingespeiste Signal im Wesentlichen auf dem Außenleiter 132 ausgegeben wird.

Bei einer fehlerhaften Verdrahtung, bei der die Außenleiter 121 und 122 vertauscht angeschlossen wurden, wird hingegen das auf den Außenleiter 121 eingespeiste Signal auf den Außenleiter 132 ausgegeben und das auf den Außenleiter 122 eingespeiste Signal auf den Außenleiter 131.

Im Schritt 206 werden mehrere Messsignale an der zweiten Stelle 145 erfasst. Die mehreren Messsignale können gleichzeitig oder nacheinander erfasst werden. In der Erfassungsvorrichtung 156 können die erfassten Messsignale optional vorbehandelt werden, beispielsweise durch Filterung. Beispielsweise können die Messsignale mit analogen und/oder digitalen Filtern vorverarbeitet werden, um zum Beispiel Störungen durch resistive, induktive oder kapazitive Kopplungen zu unterdrücken, beispielsweise einen resistiven Spannungsabfall durch Stromfluss über einen gemeinsamen Rückleiter. Derartige Störungen können beispielsweise von benachbarten im Betrieb befindlichen Systemen auf die Außenleiter 120 bis 122 und 130 bis 132 wirken. Ferner können beispielsweise Kerbfilter für Netzfrequenzen, zum Beispiel mit 50 Hz, 60 Hz oder 16,7 Hz oder einer Kombination daraus, verwendet werden, um Störungen von benachbarten Systemen herauszufiltern. Weitere Kerbfilter können für höhere Harmonische der Netzfrequenz zur Filterung der Messsignale eingesetzt werden. Alternativ oder zusätzlich können Tiefpassfilter zur Entfernung höherer Harmonischer und anderer Störungen auf die Messsignale angewendet werden. Eine Grenzfrequenz kann dabei höher als die Frequenz der höchsten verwendeten Harmonischen im Prüfsignale sein. Schließlich kann ein Hochpassfilter zur Entfernung niederfrequenter Störungen auf die Messsignale angewendet werden, wobei die Grenzfrequenz niedriger als die Grundfrequenz der Prüfsignale sein kann. Durch die Vorverarbeitung der Messsignale kann die Zuverlässigkeit der Überprüfung der Verdrahtung und die Störempfindlichkeit gegenüber benachbarten im Betrieb befindlichen Systemen erhöht werden.

Im Schritt 208 erfolgt eine Bestimmung einer Zuordnung zwischen Prüfsignalen und Messsignalen. Anders ausgedrückt erfolgt im Schritt 208 eine Identifikation der Prüfsignale in den Messsignalen. Die Identifikation der einzelnen Prüfsignale in den Messsignalen kann mittels schmalbandiger Filter oder einer diskreten Fourier Transformation für die vierten und fünften Harmonischen erfolgen. Wurde die Grundfrequenz $f_g$ wie zuvor beschrieben geeignet gewählt, beispielsweise zu 52,63 Hz, so ergeben sich keine Überschneidungen mit der Netzfrequenz oder höheren Harmonischen der Netzfrequenz.

Durch einen Vergleich der Amplitude der Grundschwingung des jeweiligen Messsignals mit den Amplituden der höheren Harmonischen, beispielsweise mit den Amplituden der vierten und fünften Harmonischen, können die Signalformen $P_1(t)$, $P_2(t)$ und $P_3(t)$ unterschieden werden. Da die relevanten Harmonischen des Prüfsignals in der energietechnischen Anlage 100 im normalen Betrieb nicht vorkommen, kann mit verhältnismäßig niedrigen Schwellenwerten verglichen werden, beispielsweise 1% oder 4% der Grundschwingung. Dadurch können auch schwache Signale noch eindeutig zugeordnet werden. Die nachfolgende Tabelle zeigt ein Beispiel für die Erkennung der Prüfsignale mit dem Schwellenwert 1%.

| $H_4$ | $H_5$ | Erkanntes Signal |
|---|---|---|
| > 1% $H_1$ (vorhanden) | < 1% $H_1$ (nicht vorhanden) | Phase 1 $P_1(t)$ |
| < 1% $H_1$ (nicht vorhanden) | > 1% $H_1$ (vorhanden) | Phase 2 $P_2(t)$ |
| < 1% $H_1$ (nicht vorhanden) | < 1% $H_1$ (nicht vorhanden) | Phase 3 $P_3(t)$ |
| > 1% $H_1$ (vorhanden) | > 1% $H_1$ (vorhanden) | Summensignal $P_S(t)$ |

Beispielsweise wird das Prüfsignal $P_1(t)$ erkannt, wenn die Amplitude der vierten Harmonischen größer als 1% der Amplitude der Grundschwingung ist und die Amplitude der fünften Harmonischen kleiner als 1% der Amplitude der Grundschwingung ist. Das Prüfsignal $P_2(t)$ wird erkannt, wenn die Amplitude der vierten Harmonischen kleiner als 1% der Amplitude der Grundschwingung ist und die Amplitude der fünften Harmonischen größer als 1% der Amplitude der Grundschwingung ist. Das Prüfsignal $P_3(t)$ wird erkannt, wenn die Amplitude der vierten Harmonischen kleiner als 1% der Amplitude der Grundschwingung ist und die Amplitude der fünften Harmonischen kleiner als 1% der Amplitude der Grundschwingung ist. Ein Summensignal der drei Prüfsignale $P_1(t)$, $P_2(t)$ und $P_3(t)$ weist sowohl die vierte als auf die fünfte Harmonische auf, sodass das Summensignal $Ps(t)$ erkannt wird, wenn die Amplitude der vierten Harmonischen größer als 1% der Amplitude der Grundschwingung ist und die Amplitude der fünften Harmonischen größer als 1% der Amplitude der Grundschwingung ist.

In dem obigen Beispiel wurden die Prüfsignale mit einer jeweils unterschiedlichen Kombination von vierter und fünfter Harmonischer erzeugt. Um beispielsweise eine höhere Robustheit zu erreichen, können weitere Harmonische verwendet werden. Die nachfolgende Tabelle zeigt beispielsweise eine Kodierung unter Verwendung der vierten, fünften und sechsten Harmonischen mit einer Hamming-Distanz zwei und einer geraden Parität.

| Phase $p$ | Kodierung | $H_4(p)$ | $H_5(p)$ | $H_6(p)$ |
|---|---|---|---|---|
| 1 | 100 | $\frac{1}{4^2}$ (vorhanden) | 0 (nicht vorhanden) | 0 (nicht vorhanden) |
| 2 | 010 | 0 (nicht vorhanden) | $\frac{1}{5^2}$ (vorhanden) | 0 (nicht vorhanden) |
| 3 | 001 | 0 (nicht vorhanden) | 0 (nicht vorhanden) | $\frac{1}{6^2}$ (vorhanden) |

In weiteren Beispielen kann nicht nur das Vorhandensein oder Nichtvorhandensein einer Harmonischen zur Kodierung verwendet werden, sondern auch die Amplitude. Beispielsweise kann lediglich die vierte Harmonische verwendet werden, die jedoch für die unterschiedlichen Prüfsignale unterschiedliche Amplituden aufweist:

| Phase $p$ | Kodierung | $H_4(p)$ |
|---|---|---|
| 1 | 00 | $\frac{1}{4^2}$ |
| 2 | 01 | $\frac{2}{3}\frac{1}{4^2}$ |
| 3 | 10 | $\frac{1}{3}\frac{1}{4^2}$ |

Die Schwellenwerte zur Erkennung der unterschiedlichen Amplituden der vierten Harmonischen sind entsprechend anzupassen. In dem oben gezeigten Beispiel wurden verhältnismäßig kleine Amplituden für die vierte Harmonische verwendet. Die Amplitude einer Harmonischen, zum Beispiel der vierten Harmonischen, kann auch größer gewählt werden, also größer als beispielsweise 1/16. Dabei ist zu beachten, dass die Asymmetrie im Zeitbereich hinreichend signifikant bleibt. Bei entsprechender Kodierung können so nicht nur einzelne Phasen, sondern auch verschiedene Phasenkombinationen voneinander unterschieden werden.

Anhand der im Schritt 208 bestimmten Zuordnung zwischen Prüfsignalen und Messsignalen kann auf einfache Art und Weise festgestellt werden, ob die erwarteten Prüfsignale an den entsprechenden Außenleitern 130 bis 132 erfasst wurden. Bei nicht erwartungsgemäßen Zuordnungen kann eine fehlerhafte Verdrahtung festgestellt werden.

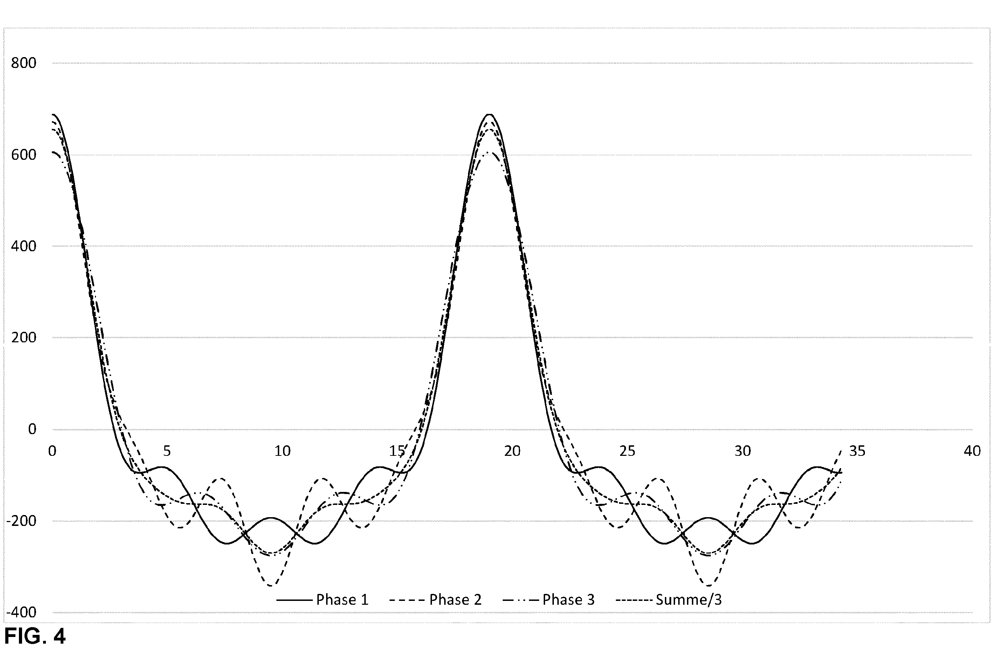

Im Schritt 210 werden Polaritäten der Messsignale, welche an der zweiten Stelle 145 erfasst wurden, bestimmt. Die Erkennung der Polarität basiert auf der im Zeitbereich asymmetrischen Signalform. Für die Messsignale, welche wie zuvor beschrieben vorbehandelt sein können, werden jeweilige Ableitungen im Zeitbereich gebildet. Eine jeweilige Ableitung kann zum Beispiel durch eine zeitdiskrete numerische Ableitung unter Verwendung von Differenzen zeitlich aufeinander erfasster Signalpegel oder implizit durch entsprechend angepasste Filterstrukturen ermittelt werden, zum Beispiel durch die Verwendung eines analogen Operationsverstärkers als Differenzierschaltung oder in digitalen Filterstrukturen. Fig. 4 zeigt resultierende Ableitungen $dM_p(t)/dt$ für die Messsignale $M_p(t)$ für die Phasen $p$ = 1, 2 und 3 sowie für das Summensignal. Für jede der Ableitungen kann ein sprechendes Hilfssignal $Q_p(t)$ gebildet werden, zum Beispiel gemäß der folgenden Vorschrift:

$$Q_p(t) = \begin{cases} 1, \text{wenn } \dfrac{M_p(t)}{dt} > \delta \\ -1, \text{wenn } \dfrac{M_p(t)}{dt} < -\delta \\ 0, \text{sonst} \end{cases}$$

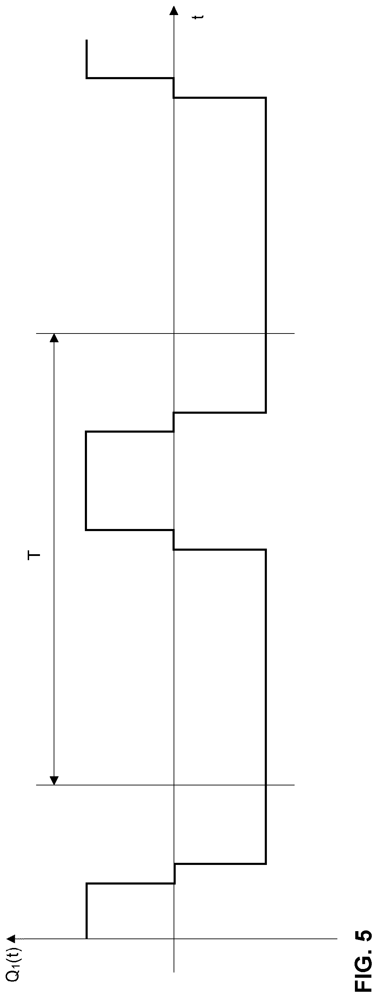

Dabei ist $\delta$ Schwellenwert, welcher verwendet wird, um Rauschen und andere unerwünschte Störungen zu unterdrücken. Fig. 5 zeigt beispielhaft das Hilfssignal $Q_1(t)$ für das Prüfsignal für Phase 1. Basierend auf dem Hilfssignal $Q_p(t)$ wird ein entsprechender Mittelwert $\overline{Q_p(t)}$ über eine bestimmte Zeit berechnet. Dieser Mittelwert kann beispielsweise über eine diskrete Zeit, beispielsweise eine Periodendauer T der Grundschwingung der Prüfsignale oder kontinuierlich mittels eines Tiefpassfilters berechnet werden. Überschreitet dieser Mittelwert eine definierte positive Schwelle, so wird eine positive Polarität angezeigt (kurze steigende Flanke und lange fallende Flanke). Unterschreitet der Mittelwert eine definierte negative Schwelle, wird eine negative Polarität angezeigt (lange steigende Flanke und kurze fallende Flanke). Ein Polaritätswechsel, welcher beispielsweise aufgrund einer fehlerhaften Verdrahtung auftreten kann, kann somit auf einfache Art und Weise für jede Phase bestimmt werden.

Im Schritt 212 können die so bestimmten Phasenzuordnungen und Polaritäten beispielsweise auf einer Anzeigevorrichtung für einen Benutzer ausgegeben werden.

Beispielsweise kann auf Leitung 170 ein erstes Prüfsignal für Phase 1 ausgegeben werden, auf Leitung 171 ein zweites Prüfsignal für Phase 2 und auf Leitung 172 ein drittes Prüfsignal für Phase 3. Bei richtiger Verdrahtung der elektrischen Anlage 100 zeigt die Prüfvorrichtung 150 für die Leitung 180 an, dass das erste Prüfsignal erkannt wurde, für die Leitung 181, dass das zweite Prüfsignal erkannt wurde, und für die Leitung 182, dass das dritte Prüfsignal erkannt wurde. Ferner kann die Prüfvorrichtung 150 anzeigen, dass die Prüfsignale jeweils mit positiver Polarität ausgegeben und erkannt wurden. Verdrahtungsfehler, beispielsweise vertauschte Außenleiter oder eine Fehlverdrahtung, die zu einer Invertierung der Polarität führt, beispielsweise an einem Transformator, können anhand der Ausgaben von einer Bedienperson identifiziert werden.

Alternativ oder zusätzlich können im Schritt 214 die erkannten Phasenzuordnungen mit Soll-Zuordnungen und/oder die erkannten Polaritäten mit Soll-Polaritäten verglichen werden und automatisch eine Warnung ausgegeben werden, wenn eine Abweichung zwischen dem erkannten Zustand und dem Soll-Zustand festgestellt wurde.

Die elektrische Anlage 100 kann noch weitere Anschlüsse aufweisen, beispielsweise weitere dreiphasige Anschlüsse, deren Verdrahtung auf gleiche Art und Weise wie zuvor beschrieben überprüft werden kann. Diese Anschlüsse können beispielsweise Hilfsstromkreise oder Steuerstromkreise betreffen, die je nach Art des Stromkreises auch mit dem obigen Verfahren geprüft werden können.

Werden mehrere Stromkreise bzw. Phasen geprüft, können diese einen gemeinsamen Neutralleiter verwenden (N für L1, L2 und L3) oder komplett getrennte Stromkreise (L1+N1, L2+N2, L3+N3) sein. Auch hier sind verschiedene Verdrahtungsfehler denkbar und können mit dem Verfahren erkannt werden. Bei Verdrahtungsfehlern können mehrfache Erdverbindungen vorkommen. Mittels beispielsweise einer Stromzange kann der Strom über die Erdverbindung als einer der mehreren Messsignale gemessen werden. Durch das beschriebene Verfahren kann über die Zuordnungen erkannt werden, welche Prüfsignale in der Erdverbindung erkannt werden konnten und somit können gewünschte und ungewünschte Erdverbindungen identifiziert werden.

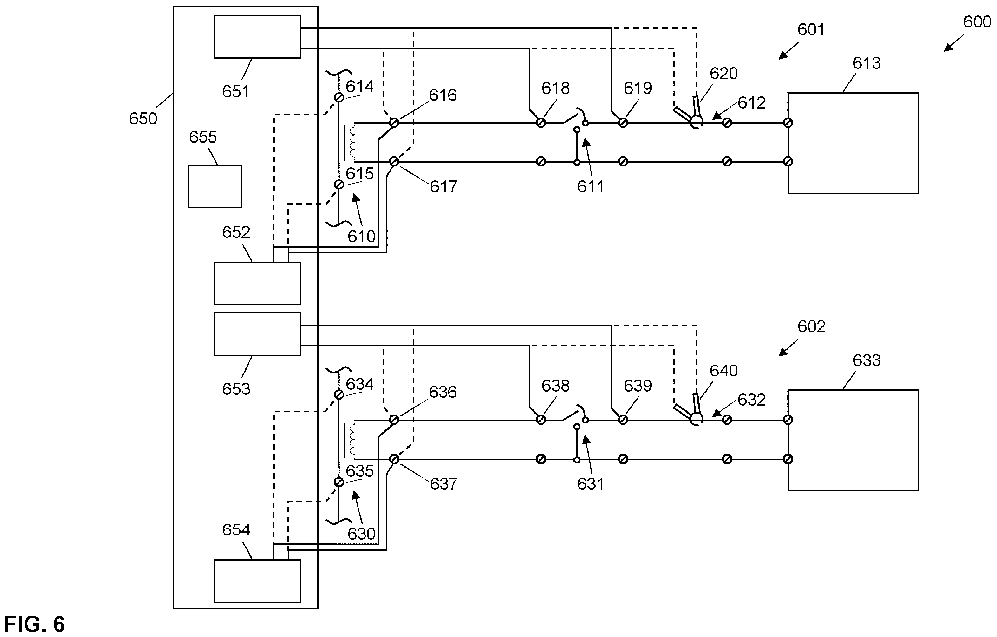

Fig. 6 zeigt schematisch einen Ausschnitt einer weiteren elektrischen Anlage 600, an welche eine Prüfvorrichtung 650 zum Prüfen einer Verdrahtung der elektrischen Anlage 600 angeschlossen ist. Die elektrische Anlage 600 umfasst mehrere Stromkreise, welche einer oder mehreren Phasen zugeordnet sein können. In dem in Fig. 6 gezeigten Beispiel umfasst die elektrische Anlage 600 zwei Stromkreise 601 und 602, welche im Wesentlichen voneinander getrennt sind. Die Stromkreise 601 und 602 können jedoch auch einer Phase eines mehrphasigen Systems, also derselben Phase des mehrphasigen Systems, oder mehreren unterschiedlichen Phasen eines mehrphasigen Systems zugeordnet sein oder über ihre Neutralleiter miteinander verbunden sein. In anderen Beispielen kann die elektrische Anlage 600 mehr als zwei Stromkreise umfassen. Die elektrische Anlage 600 kann beispielsweise eine Hochspannungsanlage oder einen Teil davon umfassen. Jeder der Stromkreise 601 und 602 kann eine oder mehrere elektrische Komponente umfassen, beispielsweise Strom- oder Spannungswandler 610, 630, Sekundärverkabelung 612, 632, Anpasswandler, Prüfstecker 614-619, 634-639, Prüfschalter 611, 631, Zähler und/oder Schutzgeräte, wie zum Beispiel Relais 613, 633.

Nach einer Installation oder Reparatur an der elektrischen Anlage 600 kann es erforderlich sein, die Verdrahtung zu überprüfen. Um die Verdrahtung zu überprüfen, kann die in Fig. 6 gezeigte Prüfvorrichtung 650 elektrisch mit beiden Stromkreisen 601 und 602 gekoppelt werden.

Die Prüfvorrichtung 650 umfasst mehrere Prüfsignalerzeugungsvorrichtungen, welche mehrere Prüfsignale erzeugen. In Fig. 6 sind zwei Prüfsignalerzeugungsvorrichtungen 652 und 654 zur Erzeugung von zwei Prüfsignalen gezeigt. Die mehreren Prüfsignale können auch von einer gemeinsamen Prüfsignalerzeugungsvorrichtung erzeugt werden. Jeder der Prüfsignalerzeugungsvorrichtungen 652 und 654 ist eine entsprechende (nicht gezeigte) Einspeisevorrichtung zugeordnet, mit welcher die Prüfsignale über entsprechende Leitungen an entsprechenden Einspeisestellen in die elektrischen Anlage 600 eingespeist werden. Die Einspeisevorrichtungen können beispielsweise die Prüfsignale von den Prüfsignalerzeugungsvorrichtungen 652, 654 an einen an der entsprechenden Einspeisestelle erforderlichen Nominalbereich anpassen. In dem in Fig. 6 gezeigten Beispiel kann das Prüfsignal von der Prüfsignalerzeugungsvorrichtung 652 beispielsweise an Prüfsteckern 616, 617 an einer Sekundärseite eines Wandlers 610, beispielsweise eines Stromwandlers oder Spannungswandlers, eingespeist werden. Alternativ kann das Prüfsignal von der Prüfsignalerzeugungsvorrichtung 652 auch an Prüfsteckern 614, 615 an einer Primärseite des Wandlers 610 eingespeist werden, wie es durch die gestrichelten Leitungen gezeigt ist. Durch Einspeisen an der Primärseite kann zusätzlich die Polarität und Verkabelung des Wandlers 610 überprüft werden. Bei einer Einspeisung an der Primärseite können bei Stromwandlern entsprechend höhere Ströme und bei Spannungswandlern entsprechend höhere Spannungen erforderlich sein. Ebenso kann das Prüfsignal von der Prüfsignalerzeugungsvorrichtung 654 beispielsweise an Prüfsteckern 636, 637 an einer Sekundärseite eines Wandlers 630 eingespeist werden. Alternativ kann das Prüfsignal von der Prüfsignalerzeugungsvorrichtung 654 auch an Prüfsteckern 634, 635 an einer Primärseite des Wandlers 630 eingespeist werden, wie es durch die gestrichelten Leitungen gezeigt ist, um zusätzlich die Polarität und Verkabelung des Wandlers 630 zu überprüfen.

Die Prüfvorrichtung 650 umfasst weiterhin mehrere Erfassungsvorrichtungen zum Erfassen von Messsignalen. In dem Beispiel der Fig. 6 umfasst die Prüfvorrichtung 650 zwei Erfassungsvorrichtungen 651 und 653, welche über entsprechende Leitungen mit dem ersten bzw. zweiten Stromkreis 601, 602 gekoppelt sind. Beispielsweise kann die Erfassungsvorrichtung 651 mit Prüfsteckern 618, 619 an dem Prüfschalter 611 gekoppelt werden, um eine Spannung an dem Prüfschalter 611 als Messsignal zu erfassen. Wie durch die gestrichelten Leitungen dargestellt, kann die Erfassungsvorrichtung 651 alternativ mit Prüfsteckern 616, 617 zur Erfassung einer Spannung an der Sekundärseite des Wandlers 610 oder mit einer Stromzange 620 zur Erfassung eines Stroms durch die Verkabelung 612 gekoppelt werden. Auf gleiche Art und Weise kann die Erfassungsvorrichtung 653 mit dem zweiten Stromkreis 602 gekoppelt werden. Wie in Fig. 6 gezeigt, kann die Erfassungsvorrichtung 653 mit den Prüfsteckern 638, 639 an dem Prüfschalter 631 gekoppelt werden, um eine Spannung an dem Prüfschalter 631 als Messsignal zu erfassen. Alternativ kann die Erfassungsvorrichtung 653 mit Prüfsteckern 636, 637 zur Erfassung einer Spannung an der Sekundärseite des Wandlers 630 oder mit einer Stromzange 640 zu Erfassung eines Stroms durch die Verkabelung 632 gekoppelt werden.

Die Prüfvorrichtung 650 umfasst weiterhin eine Verarbeitungsvorrichtung 655, welche in der Fig. 6 als eigene Komponente gezeigt ist. In anderen Beispielen kann die Verarbeitungsvorrichtung 655 auch integriert mit einer der Prüfsignalerzeugungsvorrichtungen 652, 654 oder der Erfassungsvorrichtungen 651, 653 ausgebildet sein. Die Verarbeitungsvorrichtung 655 umfasst beispielsweise eine elektronische Steuerung, beispielsweise eine Mikroprozessorsteuerung, welche beispielsweise ein Computerprogramm ausführen kann. Die Verarbeitungsvorrichtung 655 kann mit den Prüfsignalerzeugungsvorrichtungen 652, 654 und den Erfassungsvorrichtungen 651, 653 gekoppelt sein, um diese in einer koordinierten Art und Weise anzusteuern, wie es nachfolgend im Detail beschrieben werden wird. In anderen Beispielen ist die Verarbeitungsvorrichtung nicht mit den Prüfsignalerzeugungsvorrichtungen 652, 654 verbunden und die Prüfsignalerzeugungsvorrichtungen 652, 654 erzeugen die Prüfsignale unabhängig von einer Steuerung durch die Verarbeitungsvorrichtung 655. Die Prüfsignalerzeugungsvorrichtungen 652, 654, die Erfassungsvorrichtungen 651, 653 und die Verarbeitungsvorrichtung 655 müssen nicht in ein und demselben Gehäuse oder in einer Einheit ausgebildet sein, sondern können räumlich unabhängige Einheiten mit eigenen Gehäusen umfassen. Beispielsweise können die Prüfsignalerzeugungsvorrichtungen 652, 654 jeweils eine Einheit bilden, welche unabhängig betrieben und aufgestellt werden können. Eine weitere Einheit kann die Erfassungsvorrichtungen 651, 653 und die Verarbeitungsvorrichtung 655 umfassen und mit den Prüfsignalerzeugungsvorrichtungen 652, 654 gekoppelt sein. Dadurch kann auch bei großen elektrischen Anlagen, bei denen die Einspeisestellen räumlich weit von den Messstellen entfernt sind, die Prüfvorrichtung 650 verwendet werden, ohne dass entsprechend lange Leitungen zwischen den Prüfsignalerzeugungsvorrichtungen 652, 654 und den entsprechenden Einspeisestellen erforderlich sind.

Die Arbeitsweise der Prüfvorrichtung 650 entspricht im Wesentlichen der zuvor unter Bezugnahme auf die Figuren 1 bis 5 im Detail beschriebenen Arbeitsweise der Prüfvorrichtung 150. Wie zuvor beschrieben, kann das in Fig. 2 gezeigte Verfahren 200 von der Prüfvorrichtung 650 ausgeführt werden, um die Verdrahtung der elektrischen Anlage 600 zu prüfen.

Im Schritt 202 werden in diesem Fall zwei Prüfsignale erzeugt. Für jeden Stromkreis 601, 602 wird ein eigenes Prüfsignal $P_p(t)$ erzeugt, welches eine im Zeitbereich asymmetrische Signalform und eine Kombination von Harmonischen aus einer vorgegebenen Gruppe von höheren Harmonischen aufweist. Der Index $p$ bezeichnet den Stromkreis, für den das Prüfsignal $P_p(t)$ vorgesehen ist, zum Beispiel $p=1$ für den Stromkreis 601 und $p=2$ für den Stromkreis 602. Die Kombinationen von Harmonischen der mehreren Prüfsignale sind unterschiedlich, sodass die Prüfsignale auch unterschiedlich sind. Beispielsweise können die Prüfsignale auf einem gemeinsamen Signal $P(t)$ basieren, welches eine im Zeitbereich asymmetrische Signalform hat. Die Signalform des gemeinsamen Signals $P(t)$ kann einer Sägezahnsignalform angenähert sein. Dazu können beispielsweise Sinussignale mit verschiedener Amplitude und Frequenz verwendet werden, welche mittels Fourier-Synthese die Sägezahnsignalform annähernd nachbilden. Beispielsweise kann als gemeinsames Signal $P(t)$ ein Signal gemäß folgender Gleichung verwendet werden:

$$P(t) = A \sum_{n=1}^{k} \frac{1}{n^2} \sin\left(2\pi n f_g t\right)$$

A stellt hier die Amplitude des gesamten Signals dar, $k$ die Anzahl der verwendeten Harmonischen und $f_g$ die Grundfrequenz des Signals. Der Term $\frac{1}{n^2}$ gewichtet die einzelnen Sinusfunktionen, um in Summe die Sägezahnsignalform anzunähern.

Beispielsweise kann ein Signal mit $A = 1$, $k = 3$ und $f_g = 52,63$ Hz gebildet werden. In anderen Beispielen kann $A$ auch so gewählt werden, dass ein Effektivwert (RMS) des Signals annähernd 1 beträgt.

Jedes der Prüfsignale $P_p(t)$ umfasst weitere höhere Harmonische. Beispielsweise umfasst das Prüfsignal $P_1(t)$ zusätzlich die vierte Harmonische und das Prüfsignal $P_2(t)$ zusätzlich die fünfte Harmonische. Insgesamt ergeben sich für die zwei Stromkreise 601, 602 die Prüfsignale beispielsweise gemäß folgender Gleichung und Tabelle:

$$P_p(t) = A \sum_{n=1}^{k} H_n(p) \sin\left(2\pi n f_g t\right)$$

| Signal | Harmonische $H_n(p)$ | | | | |
|--------|------|------|--------|--------|------|
| $n$ | 1 | 2 | 3 | 4 | 5 |
| $P_1(t)$ | 1,0 | 0,25 | 0,111... | 0,0625 | 0,0 |
| $P_2(t)$ | 1,0 | 0,25 | 0,111... | 0,0 | 0,04 |

In diesem Fall wurde im Prinzip eine binäre Darstellung der Stromkreisnummer $p$ verwendet und die Amplituden der vierten und fünften Harmonischen entsprechend angepasst bzw. codiert:

| Stromkreis $p$ | Binäre Darstellung | $H_4(p)$ | $H_5(p)$ |
|------|------|------|------|
| 1 | 10 | $\frac{1}{4^2}$ (unverändert) | 0,0 (entfernt) |
| 2 | 01 | 0,0 (entfernt) | $\frac{1}{5^2}$ (unverändert) |

Sollen weitere Stromkreise in die Überprüfung mit aufgenommen werden, so können entsprechende binäre Darstellungen verwendet werden um die höheren harmonischen entsprechend anzupassen. Bei mehr als vier Stromkreisen können weitere Harmonische verwendet werden, zum Beispiel $H_6(p)$ und/oder $H_7(p)$. Die Prüfsignale haben eine im Zeitbereich asymmetrische Signalform, wodurch, wie später beschrieben werden wird, die Polarität unterschieden werden kann. Die Grundfrequenz der Prüfsignale kann so gewählt werden, dass ein zeitlich variables Signal entsteht, welches über Strom- oder Spannungswandler der Anlage 600 übertragen werden kann, beispielsweise über Transformatoren und/oder Kapazitäten. Details dazu wurden zuvor in Verbindung mit den Figuren 1 bis 5 erörtert und gelten für das Beispiel der Fig. 6 auf gleiche Art und Weise, wobei beispielsweise die Phase 1 dem Stromkreis 601 entspricht und die Phase 2 dem Stromkreis 602.

Im Schritt 204 werden die erzeugten Prüfsignale in die Stromkreise 601, 602 wie zuvor beschrieben eingespeist. Die Prüfsignale können gleichzeitig eingespeist werden. Die so eingespeisten Prüfsignale laufen durch die elektrischen Komponenten, die beispielsweise ein oder mehrere Transformatoren oder Kapazitäten oder sonstige elektrotechnische Einrichtungen, wie zum Beispiel Leistungsschalter oder Prüfschalter umfassen. An den oben beschriebenen Messstellen werden aufgrund der eingespeisten Prüfsignale Ausgangssignale erzeugt. Bei richtig angeschlossenen elektrischen Komponenten wird beispielsweise erwartet, dass das Prüfsignal, welches in den Stromkreis 601 eingespeist wurde, im Wesentlichen an den Prüfsteckern 618, 619 des Prüfschalters 611 ausgegeben wird, beispielsweise mit veränderter Spannung im Falle einer Einspeisung an den Prüfsteckern 614, 615. Die Signalform wäre jedoch erwartungsgemäß im Wesentlichen unverändert. Ebenso wird bei richtig angeschlossenen elektrischen Komponenten beispielsweise erwartet, dass das in den Stromkreis 602 eingespeiste Signal im Wesentlichen an den Prüfsteckern 638, 639 des Prüfschalters 631 ausgegeben wird.

Bei einer fehlerhaften Verdrahtung, bei der beispielsweise Leitungen des ersten Stromkreises 601 und Leitungen des zweiten Stromkreises 602 vertauscht angeschlossen wurden, könnte hingegen das in den ersten Stromkreis 601 eingespeiste Signal in dem zweiten Stromkreis 602 vorhanden sein und/oder das in den zweiten Stromkreis 602 eingespeiste Signal in dem ersten Stromkreis 601 vorhanden sein.

Im Schritt 206 werden mehrere Messsignale erfasst, beispielsweise wie zuvor beschrieben an den Prüfschaltern 611 und 631. Die mehreren Messsignale können gleichzeitig oder nacheinander erfasst werden. In den Erfassungsvorrichtungen 651, 653 können die erfassten Messsignale optional vorbehandelt werden, beispielsweise durch Filterung.

Im Schritt 208 erfolgt eine Bestimmung einer Zuordnung zwischen Prüfsignalen und Messsignalen. Anders ausgedrückt erfolgt im Schritt 208 eine Identifikation der Prüfsignale in den Messsignalen. Die Identifikation der einzelnen Prüfsignale in den Messsignalen kann mittels schmalbandiger Filter oder einer diskreten Fourier Transformation für die vierten und fünften Harmonischen erfolgen.

Durch einen Vergleich der Amplitude der Grundschwingung des jeweiligen Messsignals mit den Amplituden der höheren Harmonischen, beispielsweise mit den Amplituden der vierten und fünften Harmonischen, können die Signalformen $P_1(t)$ und $P_2(t)$ unterschieden werden. Da die relevanten Harmonischen des Prüfsignals in der energietechnischen Anlage 600 im normalen Betrieb nicht vorkommen, kann mit verhältnismäßig niedrigen Schwellenwerten verglichen werden, beispielsweise 1% oder 4% der Grundschwingung. Dadurch können auch schwache Signale noch eindeutig zugeordnet werden.

Anhand der im Schritt 208 bestimmten Zuordnung zwischen Prüfsignalen und Messsignalen kann auf einfache Art und Weise festgestellt werden, ob die erwarteten Prüfsignale an den entsprechenden Prüfsteckern 618, 619, 638 und 639 erfasst wurden. Bei nicht erwartungsgemäßen Zuordnungen kann eine fehlerhafte Verdrahtung festgestellt werden.

Im Schritt 210 werden Polaritäten der Messsignale, welche an den Prüfsteckern 618, 619, 638 und 639 erfasst wurden, bestimmt. Die Erkennung der Polarität basiert auf der im Zeitbereich asymmetrischen Signalform, wie es zuvor unter Bezugnahme auf die elektrische Anlage 150 beschrieben wurde.

Im Schritt 212 können die so bestimmten Stromkreiszuordnungen und Polaritäten beispielsweise auf einer Anzeigevorrichtung für einen Benutzer ausgegeben werden.

Alternativ oder zusätzlich können im Schritt 214 die erkannten Stromkreiszuordnungen mit Soll-Zuordnungen und/oder die erkannten Polaritäten mit Soll-Polaritäten verglichen werden. Eine Warnung kann automatisch ausgegeben werden, wenn eine Abweichung zwischen dem erkannten Zustand und dem Soll-Zustand festgestellt wurde.

Zusammenfassend ermöglichen die oben beschriebenen unterschiedlichen Prüfsignale, welche eine im Zeitbereich asymmetrischen Signalform und unterschiedliche Kombinationen von höheren Harmonischen aufweisen, eine schnelle und zuverlässige Überprüfung der Verdrahtung der elektrischen Anlage. Durch die Gleichstromfreiheit der Prüfsignale treten keine Sättigungseffekte in beispielsweise Transformatoren oder Kondensatoren auf, sodass die Prüfsignale problemlos über Wandler übertragbar sind. Darüber hinaus erlauben die Prüfsignale eine Erkennung von Polaritätsfehlern und eine eindeutige Unterscheidung der einzelnen Phasen. Die Schwellenwerte, welche dabei zur Identifikation der höheren Harmonischen verwendet werden, können relativ in Bezug auf die Grundschwingung gewählt werden, sind also nicht von der absoluten Amplitude der Signale abhängig. Das Verfahren funktioniert daher auch bei Teilsignalen, welche beispielsweise durch Stromaufteilung oder bei unerwünschten Erdverbindungen auftreten können. Es können auch größere Schwellenwerte verwendet werden, beispielsweise 4% statt 1%. Dadurch ist das Verfahren auch gegenüber frequenzabhängigen Amplitudenänderungen, beispielsweise einem Frequenzgang bei Wandlern, tolerant.

Für die einzelnen Prüfsignale und die Harmonischen der Prüfsignale ist es nicht notwendig, die Phasenlage auszuwerten. Daher ist dieses Verfahren tolerant gegenüber kleineren Phasenverschiebungen, wie zum Beispiel einem frequenzabhängigen Phasengang bei Wandlern. Darüber hinaus ist keine Synchronisation zwischen der Prüfsignalerzeugungsvorrichtung und der Erfassungsvorrichtung erforderlich.

Die einzelnen unterschiedlichen Prüfsignale sowie auch Linearkombinationen daraus weisen gleiche im Zeitbereich asymmetrische Eigenschaften auf und können daher zuverlässig einer Polarität zugeordnet werden.

Durch die Verwendung zusätzlicher Harmonischer und/oder zusätzlich unterschiedlicher Amplituden können mehr als drei Phasen unterschieden werden. Dies ermöglicht zum Beispiel die gleichzeitige Unterscheidung weiterer Phasen, zum Beispiel in 2 x 3 Phasensystemen, oder die Verwendung einer Kodierung mit einer Hamming-Distanz größer eins, um eine Robustheit gegenüber Amplitudenfehlern zu verbessern.

**Patentansprüche**

1. Verfahren zum Prüfen einer Verdrahtung einer elektrischen Anlage mit mehreren Stromkreisen, umfassend:

   - Erzeugen (202) mehreren Prüfsignale (160-162),
   - Einspeisen (204) der mehreren Prüfsignale (160-162) in mehrere erste Anschlüsse (142-144), die den mehreren Stromkreisen zugeordnet sind, an einer ersten Stelle (141) der elektrischen Anlage (100), wobei in jeden ersten Anschluss der mehreren ersten Anschlüsse (142-144) ein anderes Prüfsignal der mehreren Prüfsignale (160-162) eingespeist wird,

- Erfassen (206) von mehreren Messsignalen an mehreren zweiten Anschlüssen (146-148), die den mehreren Stromkreisen zugeordnet sind, an einer zweiten Stelle (145) der elektrischen Anlage (100), und

- Bestimmen (208) von Zuordnungen zwischen jeweils einem ersten Anschluss der mehreren ersten Anschlüssen (142-144) und einem zweiten Anschluss der mehreren zweiten Anschlüsse (146-148) auf der Grundlage der eingespeisten Prüfsignale (160-162) und der erfassten Messsignale, **dadurch gekennzeichnet, dass** jedes der mehreren Prüfsignale (160-162) eine im Zeitbereich asymmetrische Signalform und eine Kombination von Harmonischen aus einer vorgegebenen Gruppe von höheren Harmonischen aufweist, wobei die Kombinationen von Harmonischen der mehreren Prüfsignale (160-162) unterschiedlich sind.

2. Verfahren nach Anspruch 1, wobei die mehreren Prüfsignale (160-162) gleichzeitig in die mehreren ersten Anschlüsse (142-144) eingespeist werden.

3. Verfahren nach Anspruch 1 oder Anspruch 2, wobei die vorgegebene Gruppe von höheren Harmonischen vierte und fünfte Harmonische umfasst.

4. Verfahren nach einem der vorhergehenden Ansprüche, wobei die im Zeitbereich asymmetrische Signalform zusätzliche zu einer Grundschwingung zumindest zweite und/oder dritte Harmonische umfasst.

5. Verfahren nach einem der vorhergehenden Ansprüche, wobei eine Grundschwingung der im Zeitbereich asymmetrischen Signalform eine Frequenz ungleich einer Netzfrequenz der elektrischen Anlage aufweist.

6. Verfahren nach einem der vorhergehenden Ansprüche, wobei eine Grundschwingung der im Zeitbereich asymmetrischen Signalform eine Frequenz im Bereich von 50 bis 60 Hz aufweist, optional eine Frequenz im Bereich von 51 bis 55 Hz, weiter optional eine Frequenz von 52,63 Hz.

7. Verfahren nach einem der vorhergehenden Ansprüche, wobei eine Amplitude einer n-ten Harmonischen der Gruppe von höheren Harmonischen einen Amplitudenfaktor von $1/n^2$ bezogen auf eine Amplitude einer Grundschwingung der im Zeitbereich asymmetrischen Signalform aufweist.

8. Verfahren nach einem der vorhergehenden Ansprüche, wobei das Bestimmen (208) von Zuordnungen umfasst:

- Filtern der Messsignale mit Bandpassfiltern, deren Mittenfrequenzen den Frequenzen der Harmonischen aus der vorgegebenen Gruppe von höheren Harmonischen entsprechen, und
- Vergleichen der gefilterten Messsignale mit einem Schwellenwert.

9. Verfahren nach einem der vorhergehenden Ansprüche, wobei das Bestimmen (208) von Zuordnungen umfasst:

- Bestimmen von Amplituden von Frequenzen in den Messsignalen, die den Frequenzen der Harmonischen aus der vorgegebenen Gruppe von höheren Harmonischen entsprechen, und
- Vergleichen der bestimmten Amplituden mit einem Schwellenwert.

10. Verfahren nach Anspruch 8 oder Anspruch 9, wobei der Schwellenwert in Abhängigkeit von einer Amplitude einer Grundschwingung der im Zeitbereich asymmetrischen Signalform eingestellt wird.

11. Verfahren nach einem der vorhergehenden Ansprüche, wobei eine erste Kombination der unterschiedlichen Kombinationen eine vierte Harmonische und keine fünfte Harmonische aufweist, eine zweite Kombination der unterschiedlichen Kombinationen eine fünfte Harmonische und keine vierte Harmonische aufweist, und eine dritte Kombination der unterschiedlichen Kombinationen weder die vierte noch die fünfte Harmonische aufweist.

12. Verfahren nach einem der vorhergehenden Ansprüche, wobei eine erste Kombination der unterschiedlichen Kombinationen eine vierte Harmonische und keine fünfte und keine sechste Harmonische aufweist, eine zweite Kombination der unterschiedlichen Kombinationen eine fünfte Harmonische und keine vierte und keine sechste Harmonische aufweist, und eine dritte Kombination der unterschiedlichen Kombinationen eine sechste Harmonische und keine vierte und keine fünfte Harmonische aufweist.

13. Verfahren nach einem der vorhergehenden Ansprüche,

   wobei eine erste Kombination der unterschiedlichen Kombinationen nur eine bestimmte höhere Harmonische mit einem ersten Amplitudenfaktor aufweist, eine zweite Kombination der unterschiedlichen Kombinationen nur die bestimmte höhere Harmonische mit einem zweiten Amplitudenfaktor aufweist, und eine dritte Kombination der unterschiedlichen Kombinationen nur die bestimmte höhere Harmonische mit einem dritte Amplitudenfaktor aufweist,
   wobei der erste, zweite und dritte Amplitudenfaktor unterschiedlich sind.

14. Verfahren nach einem der vorhergehenden Ansprüche, ferner umfassend:

   - Ausgeben der Zuordnungen zwischen jeweils einem ersten Anschluss der mehreren ersten Anschlüssen und einem zweiten Anschluss der mehreren zweiten Anschlüssen an einen Benutzer, und/oder
   - Vergleichen der Zuordnungen zwischen jeweils einem ersten Anschluss der mehreren ersten Anschlüsse und einem zweiten Anschluss der mehreren zweiten Anschlüsse mit vorgegebenen Zuordnungen zwischen jeweils einem ersten Anschluss der mehreren ersten Anschlüsse und einem zweiten Anschluss der mehreren zweiten Anschlüsse.

15. Verfahren nach einem der vorhergehenden Ansprüche, ferner umfassend:

   - Bestimmen (210) von Polaritäten der erfassten Messsignale, um abhängig von den bestimmten Polaritäten die Verdrahtung der elektrischen Anlage zu prüfen.

16. Verfahren nach Anspruch 15, wobei das Bestimmen (210) von Polaritäten der erfassten Messsignale für ein jeweiliges Messsignal der erfassten Messsignale umfasst:

   - Bestimmen einer Ableitung eines jeweiligen Messsignals,
   - Erzeugen eines Vergleichssignals durch Vergleichen der Ableitung mit einem Schwellenwert,
   - Bestimmen eines Mittelwerts des Vergleichssignals, und
   - Bestimmen der Polarität des jeweiligen Messsignals in Abhängigkeit von dem Mittelwert des Vergleichssignals.

17. Verfahren nach Anspruch 15, wobei das Bestimmen (210) von Polaritäten der erfassten Messsignale für ein jeweiliges Messsignal der erfassten Messsignale umfasst:

   - Bestimmen eines Korrelationsfaktors in Abhängigkeit von einem jeweiligen Messsignal und der im Zeitbereich asymmetrische Signalform, und
   - Bestimmen der Polarität des jeweiligen Messsignals in Abhängigkeit von dem Korrelationsfaktor.

18. Prüfvorrichtung zum Prüfen einer Verdrahtung einer elektrischen Anlage mit mehreren Stromkreisen, umfassend:

   - eine Prüfsignalerzeugungsvorrichtung (152), die ausgestaltet ist, mehrere Prüfsignale (160-162) zu erzeugen,
   - eine Einspeisevorrichtung (154), die ausgestaltet ist, an einer ersten Stelle (141) der elektrischen Anlage (100) die mehreren Prüfsignale (160-162) in mehrere erste Anschlüsse (142-144), die den mehreren Stromkreisen zugeordnet sind, einzuspeisen, wobei in jeden ersten Anschluss der mehreren ersten Anschlüsse (142-144) ein anderes Prüfsignal der mehreren Prüfsignale (160-162) eingespeist wird,
   - eine Erfassungsvorrichtung (156), die ausgestaltet ist, an einer zweiten Stelle (145) der elektrischen Anlage (100) mehrere Messsignale an mehreren zweiten Anschlüssen (146-148), die den mehreren Stromkreisen zugeordnet sind, zu erfassen, und
   - eine Verarbeitungsvorrichtung (158), die ausgestaltet ist, Zuordnungen zwischen jeweils einem ersten Anschluss der mehreren ersten Anschlüsse (142-144) und einem zweiten Anschluss der mehreren zweiten Anschlüsse (146-148) auf der Grundlage der eingespeisten Prüfsignale (160-162) und der erfassten Messsignale zu bestimmen, **dadurch gekennzeichnet,**

   **dass** jedes der mehreren Prüfsignale (160-162) eine im Zeitbereich asymmetrische Signalform und eine Kombination von Harmonischen aus einer vorgegebenen Gruppe von höheren Harmonischen aufweist, wobei die Kombinationen von Harmonischen der mehreren Prüfsignale (160-162) unterschiedlich sind.

19. Prüfvorrichtung nach Anspruch 18, wobei die Prüfvorrichtung (150) zur Durchführung des Verfahrens nach einem der Ansprüche 1-17 ausgestaltet ist.

**Claims**

1. Method for testing a wiring of an electrical installation having a plurality of circuits, comprising:

   - generating (202) a plurality of test signals (160-162),
   - feeding (204) the plurality of test signals (160-162) into a plurality of first terminals (142-144), associated with the plurality of circuits, at a first location (141) of the electrical installation (100), wherein another test signal of the plurality of test signals (160-162) is fed into each first terminal of the plurality of first terminals (142-144),
   - detecting (206) a plurality of measurement signals at a plurality of second terminals (146-148), associated with the plurality of circuits, at a second location (145) of the electrical installation (100), and
   - determining (208) associations between respectively a first terminal of the plurality of first terminals (142-144) and a second terminal of the plurality of second terminals (146-148) based on the fed test signals (160-162) and the detected measurement signals, **characterized in that** each of the plurality of test signals (160-162) has an asymmetrical waveform in the time domain and a combination of harmonics from a predetermined group of higher harmonics, wherein the combinations of harmonics of the plurality of test signals (160-162) are different.

2. Method according to claim 1, wherein the plurality of test signals (160-162) are simultaneously fed into the plurality of first terminals (142-144).

3. Method according to claim 1 or claim 2, wherein the predetermined group of higher harmonics comprises fourth and fifth harmonics.

4. Method according to any one of the preceding claims, wherein the asymmetric waveform in the time domain comprises at least second and/or third harmonics in addition to a fundamental oscillation.

5. Method according to any one of the preceding claims, wherein a fundamental oscillation of the asymmetrical waveform in the time domain has a frequency unequal to a mains frequency of the electrical installation.

6. Method according to any one of the preceding claims, wherein a fundamental oscillation of the asymmetric waveform in the time domain has a frequency in the range of 50 to 60 Hz, optionally a frequency in the range of 51 to 55 Hz, further optionally a frequency of 52.63 Hz.

7. Method according to any one of the preceding claims, wherein an amplitude of an n-th harmonic of the group of higher harmonics has an amplitude factor of $1/n^2$ relative to an amplitude of a fundamental oscillation of the asymmetric waveform in the time domain.

8. Method according to any one of the preceding claims, wherein determining (208) associations comprises:

   - filtering the measurement signals with bandpass filters whose centre frequencies correspond to the frequencies of the harmonics from the predetermined group of higher harmonics, and
   - comparing the filtered measurement signals with a threshold value.

9. Method according to any one of the preceding claims, wherein determining (208) associations comprises:

   - determining amplitudes of frequencies in the measurement signals corresponding to the frequencies of the harmonics from the predetermined group of higher harmonics, and
   - comparing the determined amplitudes with a threshold value.

10. Method according to claim 8 or claim 9, wherein the threshold value is set as a function of an amplitude of a fundamental oscillation of the asymmetric waveform in the time domain.

11. Method according to any one of the preceding claims, wherein a first combination of the different combinations has a fourth harmonic and no fifth harmonic, a second combination of the different combinations has a fifth harmonic and no fourth harmonic, and a third combination of the different combinations has neither the fourth nor the fifth harmonic.

12. Method according to any one of the preceding claims, wherein a first combination of the different combinations has a fourth harmonic and no fifth harmonic, a second combination of the different combinations has a fifth harmonic and no fourth harmonic, and a third combination of the different combinations has no fourth and no fifth harmonic.

13. Method according to any one of the preceding claims,

wherein a first combination of the different combinations has only a determined higher harmonic with a first amplitude factor, a second combination of the different combinations has only the determined higher harmonic with a second amplitude factor, and a third combination of the different combinations has only the determined higher harmonic with a third amplitude factor,
where the first, second and third amplitude factors are different.

14. Method according to any one of the preceding claims, further comprising:

- outputting the associations between respectively a first terminal of the plurality of first terminals and a second terminal of the plurality of second terminals to a user, and/or
- comparing the associations between respectively a first terminal of the plurality of first terminals and a second terminal of the plurality of second terminals with predetermined associations between respectively a first terminal of the plurality of first terminals and a second terminal of the plurality of second terminals.

15. Method according to any one of the preceding claims, further comprising:

- determining (210) polarities of the detected measurement signals to test the wiring of the electrical system depending on the determined polarities.

16. Method according to claim 15, wherein determining (210) polarities of the detected measurement signals for a respective measurement signal of the detected measurement signals comprises:

- determining a derivative of a respective measurement signal,
- generating a comparison signal by comparing the derivative with a threshold value,
- determining a mean value of the comparison signal, and
- determining the polarity of the respective measurement signal as a function of the mean value of the comparison signal.

17. Method according to claim 15, wherein determining (210) polarities of the detected measurement signals for a respective measurement signal of the detected measurement signals comprises:

- determining a correlation factor as a function of a respective measurement signal and the asymmetric waveform in the time domain, and
- determining the polarity of the respective measurement signal as a function of the correlation factor.

18. Testing device for testing a wiring of an electrical installation having a plurality of circuits, comprising:

- a test signal generating device (152) configured to generate a plurality of test signals (160-162),
- a feeding device (154) configured to feed the plurality of test signals (160-162) into a plurality of first terminals (142-144), associated with the plurality of circuits, at a first location (141) of the electrical installation (100), wherein another test signal of the plurality of test signals (160-162) is fed into each first terminal of the plurality of first terminals (142-144),
- a detection device (156) configured to detect, at a second location (145) of the electrical installation (100), a plurality of measurement signals at a plurality of second terminals (146-148) associated with the plurality of circuits, and
- a processing device (158) configured to determine associations between respectively a first terminal of the plurality of first terminals (142-144) and a second terminal of the plurality of second terminals (146-148) based on the fed test signals (160-162) and the detected measurement signals, **characterized in that**
- each of the plurality of test signals (160-162) has an asymmetrical waveform in the time domain and a combination of harmonics from a predetermined group of higher harmonics, wherein the combinations of harmonics of the plurality of test signals (160-162) are different.

**19.** Testing device according to claim 18, wherein the testing device (150) is configured to carry out the method according to any one of claims 1-17.

**Revendications**

**1.** Procédé de test du câblage d'une installation électrique comportant une pluralité de circuits, comprenant :

- générer (202) la pluralité de signaux de test (160-162),
- injecter (204) la pluralité de signaux de test (160-162) dans une pluralité de premières bornes (142-144), associées à la pluralité de circuits, en un premier emplacement (141) de l'installation électrique (100), un autre signal de test de la pluralité de signaux de test (160-162) étant injecté dans chaque première borne de la pluralité de premières bornes (142-144),
- détecter (206) une pluralité de signaux de mesure sur une pluralité de deuxièmes bornes (146-148), associées à la pluralité de circuits, en un second emplacement (145) de l'installation électrique (100), et
- déterminer (208) des associations entre respectivement une première borne de la pluralité de premières bornes (142-144) et une seconde borne de la pluralité de secondes bornes (146-148) sur la base des signaux de test (160-162) injectés et des signaux de mesure détectés, **caractérisées en ce que** chacun de la pluralité de signaux de test (160-162) présente une forme d'onde asymétrique dans le domaine temporel et une combinaison d'harmoniques d'un groupe prédéterminé d'harmoniques supérieures, les combinaisons d'harmoniques de la pluralité de signaux de test (160-162) étant différentes.

**2.** Procédé selon la revendication 1, dans lequel la pluralité de signaux de test (160-162) sont injectés simultanément dans la pluralité de premières bornes (142-144).

**3.** Procédé selon la revendication 1 ou la revendication 2, dans lequel le groupe prédéterminé d'harmoniques supérieures comprend des quatrième et cinquième harmoniques.

**4.** Procédé selon l'une quelconque des revendications précédentes, dans lequel la forme d'onde asymétrique dans le domaine temporel comprend au moins des deuxième et/ou troisième harmoniques en plus d'une oscillation fondamentale.

**5.** Procédé selon l'une quelconque des revendications précédentes, dans lequel une oscillation fondamentale de la forme d'onde asymétrique dans le domaine temporel présente une fréquence différente d'une fréquence de réseau de l'installation électrique.

**6.** Procédé selon l'une quelconque des revendications précédentes, dans lequel une oscillation fondamentale de la forme d'onde asymétrique dans le domaine temporel présente une fréquence dans la plage de 50 à 60 Hz, éventuellement une fréquence dans la plage de 51 à 55 Hz, en outre éventuellement une fréquence de 52,63 Hz.

**7.** Procédé selon l'une quelconque des revendications précédentes, dans lequel une amplitude d'une n-ième harmonique du groupe d'harmoniques supérieures présente un facteur d'amplitude de $1/n^2$ par rapport à une amplitude d'une oscillation fondamentale de la forme d'onde asymétrique dans le domaine temporel.

**8.** Procédé selon l'une quelconque des revendications précédentes, dans lequel la détermination (208) des associations comprend :

- filtrer les signaux de mesure avec des filtres passe-bande dont les fréquences centrales correspondent aux fréquences des harmoniques du groupe prédéterminé d'harmoniques supérieures, et
- comparer les signaux de mesure filtrés avec un valeur seuil.

**9.** Procédé selon l'une quelconque des revendications précédentes, dans lequel la détermination (208) des associations comprend :

- déterminer les amplitudes de fréquences dans les signaux de mesure qui correspondent aux fréquences des harmoniques du groupe prédéterminé d'harmoniques supérieures, et
- comparer les amplitudes déterminées avec une valeur seuil.

10. Procédé selon la revendication 8 ou la revendication 9, dans lequel la valeur seuil est ajustée en fonction d'une amplitude d'une oscillation fondamentale de la forme d'onde asymétrique dans le domaine temporel.

11. Procédé selon l'une quelconque des revendications précédentes, dans lequel une première combinaison des différentes combinaisons présente une quatrième harmonique et ne présente aucune cinquième harmonique, une deuxième combinaison des différentes combinaisons présente une cinquième harmonique et ne présente aucune quatrième harmonique, et une troisième combinaison des différentes combinaisons ne présente ni la quatrième ni la cinquième harmonique.

12. Procédé selon l'une quelconque des revendications précédentes, dans lequel une première combinaison des différentes combinaisons présente une quatrième harmonique et ne présente aucune cinquième et aucune sixième harmonique, une deuxième combinaison des différentes combinaisons présente une cinquième harmonique et ne présente aucune quatrième et aucune sixième harmonique, et une troisième combinaison des différentes combinaisons présente une sixième harmonique et ne présente aucune quatrième et aucune cinquième harmonique.

13. Procédé selon l'une quelconque des revendications précédentes,

où une première combinaison des différentes combinaisons ne présente qu'une harmonique déterminée supérieure avec un premier facteur d'amplitude, une deuxième combinaison des différentes combinaisons ne présente que l'harmonique déterminée supérieure avec un deuxième facteur d'amplitude, et une troisième combinaison des différentes combinaisons ne présente que l'harmonique déterminée supérieure avec un troisième facteur d'amplitude,
où les premier, deuxième et troisième facteurs d'amplitude sont différents.

14. Procédé selon l'une quelconque des revendications précédentes, comprenant en outre :

- délivrer à un utilisateur les associations entre respectivement une première borne de la pluralité de premières bornes et une deuxième borne de la pluralité de deuxièmes bornes et/ou
- comparer les associations entre respectivement une première borne de la pluralité de premières bornes et une deuxième borne de la pluralité de deuxièmes bornes avec des associations prédéterminées entre respectivement une première borne de la pluralité de premières bornes et une deuxième borne de la pluralité de deuxièmes bornes.

15. Procédé selon l'une quelconque des revendications précédentes, comprenant en outre :

- déterminer (210) des polarités des signaux de mesure détectés afin de vérifier, en fonction des polarités déterminées, le câblage de l'installation électrique.

16. Procédé selon la revendication 15, dans lequel la détermination (210) de polarités des signaux de mesure détectés pour un signal de mesure respectif des signaux de mesure détectés comprend :

- déterminer une dérivée d'un signal de mesure respectif,
- générer un signal de comparaison en comparant la dérivée à une valeur seuil,
- déterminer une valeur moyenne du signal de comparaison, et
- déterminer la polarité du signal de mesure respectif en fonction de la valeur moyenne du signal de comparaison.

17. Procédé selon la revendication 15, dans lequel la détermination (210) de polarités des signaux de mesure détectés pour un signal de mesure respectif des signaux de mesure détectés comprend :

- déterminer un facteur de corrélation en fonction d'un signal de mesure respectif et de la forme d'onde asymétrique dans le domaine temporel, et
- déterminer la polarité du signal de mesure respectif en fonction du facteur de corrélation.

18. Dispositif pour tester de test du câblage d'une installation électrique comportant une pluralité de circuits, comprenant :

- un dispositif de génération de signaux de test (152) configuré pour générer une pluralité de signaux de test (160-162),
- un dispositif d'injection (154) configuré pour injecter, en un premier emplacement (141) de l'installation électrique (100), la pluralité de signaux de test (160-162) dans une pluralité de premières bornes (142-144) associées à la pluralité de circuits électriques, un autre signal de test de la pluralité de signaux de test (160-162) étant injecté dans chaque première borne de la pluralité de premières bornes (142-144),

- un dispositif de détection (156) configuré pour détecter, en un deuxième emplacement (145) de l'installation électrique (100), une pluralité de signaux de mesure sur une pluralité de deuxièmes bornes (146-148) associées à la pluralité de circuits électriques, et

- un dispositif de traitement (158) configuré pour déterminer des associations entre respectivement une première borne respective de la pluralité de premières bornes (142-144) et une deuxième borne de la pluralité de deuxièmes bornes (146-148) sur la base des signaux de test injectés (160-162) et des signaux de mesure détectés, **caractérisé**

- **en ce que** chacun de la pluralité de signaux de test (160-162) a une forme d'onde asymétrique dans le domaine temporel et une combinaison d'harmoniques d'un groupe prédéterminé d'harmoniques supérieures, les combinaisons d'harmoniques de la pluralité de signaux de test (160-162) étant différentes.

19. Dispositif pour tester selon la revendication 18, dans lequel le dispositif pour tester (150) est configuré pour mettre en œuvre le procédé selon l'une quelconque des revendications 1 à 17.

**FIG. 1**

| | |
|---|---|
| 200 ↘ | Erzeugen mehrerer Prüfsignale — 202 |
| | Einspeisen der Prüfsignale an einer ersten Stelle — 204 |
| | Erfassen mehrerer Messsignale an einer zweiten Stelle — 206 |
| | Bestimmen einer Zuordnung zwischen Prüfsignalen und Messsignalen — 208 |
| | Bestimmen von Polaritäten der Messsignale — 210 |
| | Ausgeben der Zuordnungen und/oder Polaritäten — 212 |
| | Vergleichen der Zuordnungen mit Soll-Zuordnungen und/oder Polaritäten mit Soll-Polaritäten — 214 |

**FIG. 2**

FIG. 3

EP 4 526 692 B1

FIG. 4

FIG. 5

**FIG. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014008750 A1
- US 3441842 A
- US 2004008018 A1